(19) Europäisches Patentamt
European Patent Office
Office européen des brevets

(11) **EP 4 645 690 B1**

(12) **EUROPEAN PATENT SPECIFICATION**

(45) Date of publication and mention
of the grant of the patent:
**08.07.2026 Bulletin 2026/28**

(21) Application number: **25155417.6**

(22) Date of filing: **31.01.2025**

(51) International Patent Classification (IPC):
*H03F 1/32* *(2006.01)*     *H03F 3/45* *(2006.01)*

(52) Cooperative Patent Classification (CPC):
**H03F 3/45475; H03F 1/32;** H03F 2200/153;
H03F 2200/156; H03F 2203/30036;
H03F 2203/45726

(54) **BUFFER AND INTEGRATED CIRCUIT**

PUFFER UND INTEGRIERTE SCHALTUNG

TAMPON ET CIRCUIT INTÉGRÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **29.04.2024 CN 202410534137**

(43) Date of publication of application:
**05.11.2025 Bulletin 2025/45**

(73) Proprietor: **GigaDevice Semiconductor Inc.
Haidian, Beijing (CN)**

(72) Inventor: **LIU, Yunchao
Beijing (CN)**

(74) Representative: **Herzog IP Patentanwalts GmbH
Steinstraße 16-18
40212 Düsseldorf (DE)**

(56) References cited:
**CN-B- 114 023 278     CN-C- 100 578 596
KR-B1- 100 427 039     US-A1- 2009 284 315**

**Description**

**CROSS-REFERENCE TO RELATED APPLICATIONS**

This application claims priority to Chinese patent application No. 202410534137.9 filed on April 29, 2024.

**TECHNICAL FIELD**

The disclosure herein relates to the field of integrated circuits, particularly to a buffer and related integrated circuit.

**BACKGROUND**

At present, an operational amplifier (hereinafter also referred to as "op-amp") with voltage-voltage feedback may be used as a buffer to enhance the driving capability of circuits. This buffer has the characteristics of high input impedance and low output impedance, but it may cause stability issues when driving capacitive loads.

Therefore, there is a need for a buffer that can stably drive capacitive loads.

Various schemes have been proposed for such a buffer. CN114023278B discloses an opamp-based buffer for driving different capacitive loads that can selectively/switchably adapt its feedback loop. KR100427039B1 discloses a buffer for an LCD driver, which can switch a charging state of a load capacitor. CN100578596C discloses a drive circuit for driving a capacitive load, wherein an operation state of an amplification circuit is detected and a resistance between the amplification circuit and the capacitive load is adaptively varied in response to the detected operation state. US2009/284315A1 discloses an op-amp including a phase control circuit in which a resistor connected in series with a feedback capacitor of the op-amp is adaptively adjusted to control the phase margin according to a load capacitance.

**SUMMARY**

One of the technical problems to be solved by the present disclosure is to provide a buffer and integrated circuit that can stably drive capacitive loads.

According to an embodiment of the present disclosure, a buffer is provided, the buffer comprising: an operational amplifier, whose non-inverting or inverting input terminal is coupled to an output terminal of a pre-stage circuit external to the buffer; a voltage-voltage feedback network for the operational amplifier, whose first end is coupled to the inverting input terminal of the operational amplifier; an isolation resistor, whose first end is coupled to an output terminal of the buffer; and a first set of switches and a second set of switches, configured to close the first set of switches and open the second set of switches in the case where the buffer drives a first capacitive load, and to open the first set of switches and close the second set of switches in the case where the buffer drives a second capacitive load, such that: in the case where the buffer drives the first capacitive load, an output terminal of the operational amplifier is coupled to the output terminal of the buffer via a first subset of switches of the first set of switches, and a second end of the voltage-voltage feedback network is coupled to the output terminal of the buffer via a second subset of switches of the first set of switches or directly coupled to a second end of the isolation resistor so that the isolation resistor is used as a feedback resistor for the operational amplifier, and in the case where the buffer drives the second capacitive load, the output terminal of the operational amplifier is coupled to the second end of the isolation resistor via a third subset of switches of the second set of switches, and the second end of the voltage-voltage feedback network is coupled to the output terminal of the operational amplifier via a fourth subset of switches of the second set of switches, wherein the first subset, the second subset, the third subset and the fourth subset each comprise at least one switch, and the first subset and the second subset are not identical, wherein the third subset and the fourth subset are identical in the case where the second end of the voltage-voltage feedback network is directly coupled to the second end of the isolation resistor, and the third subset and the fourth subset are not identical in the case where the second end of the voltage-voltage feedback network is not directly coupled to the second end of the isolation resistor; wherein, the capacitance value of the second capacitive load is different from that of the first capacitive load.

Optionally, the capacitance value of the second capacitive load is greater than that of the first capacitive load.

Optionally, the first set of switches includes a first switch and a second switch, the second set of switches includes a third switch and a fourth switch, wherein, the first switch is coupled between the output terminal of the operational amplifier and the output terminal of the buffer, and the second switch is coupled between the second end of the voltage-voltage feedback network and the output terminal of the buffer, and the third switch is coupled between the output terminal of the operational amplifier and the second end of the isolation resistor, and the fourth switch is coupled between the second end of the voltage-voltage feedback network and the output terminal of the operational amplifier.

Optionally, the first switch, the second switch, the third switch, and the fourth switch are all CMOS transmission gates.

Optionally, an output stage of the operational amplifier includes a first PMOS transistor and a first NMOS transistor, wherein a drain of the first PMOS transistor and a drain of the first NMOS transistor are used as the output terminals of the operational amplifier; the first set of switches includes a fifth switch, a sixth switch, and a seventh switch, the second set of switches includes an eighth switch, a ninth switch, and a tenth switch, wherein, the fifth switch is coupled between the drain of the first PMOS transistor and the output terminal of the buffer, the sixth switch is coupled between the drain of the first NMOS transistor and the output terminal of the buffer, and the seventh switch is coupled between the second end of the voltage-voltage feedback network and the output terminal of the buffer, the eighth switch is coupled between the drain of the first PMOS transistor and the second end of the voltage-voltage feedback network, the ninth switch is coupled between the drain of the first NMOS transistor and the second end of the voltage-voltage feedback network, and the tenth switch is coupled between the second end of the voltage-voltage feedback network and the second end of the isolation resistor.

Optionally, the fifth switch and the eighth switch are both PMOS switches; the sixth switch and the ninth switch are both NMOS switches; the seventh switch and the tenth switch are both CMOS transmission gates.

Optionally, an output stage of the operational amplifier includes a first PMOS transistor and a first NMOS transistor, wherein a drain of the first PMOS transistor and a drain of the first NMOS transistor are used as the output terminals of the operational amplifier; the first set of switches includes a fifteenth switch and a sixteenth switch, the second set of switches includes a seventeenth switch and an eighteenth switch, wherein the second end of the voltage-voltage feedback network is directly coupled to the second end of the isolation resistor, the fifteenth switch is coupled between the drain of the first PMOS transistor and the output terminal of the buffer, and the sixteenth switch is coupled between the drain of the first NMOS transistor and the output terminal of the buffer, the seventeenth switch is coupled between the drain of the first PMOS transistor and the second end of the voltage-voltage feedback network, and the eighteenth switch is coupled between the drain of the first NMOS transistor and the second end of the voltage-voltage feedback network.

Optionally, the fifteenth switch and the seventeenth switch are both PMOS switches; the sixteenth switch and the eighteenth switch are both NMOS switches.

Optionally, the buffer further comprises a first Miller compensation capacitor, a second Miller compensation capacitor, a third Miller compensation capacitor, and a fourth Miller compensation capacitor; the first set of switches further includes an eleventh switch and a twelfth switch; the second set of switches further includes a thirteenth switch and a fourteenth switch; wherein the eleventh switch and the first Miller compensation capacitor are coupled in series between a gate of the first PMOS transistor and the output terminal of the buffer, the twelfth switch and the second Miller compensation capacitor are coupled in series between a gate of the first NMOS transistor and the output terminal of the buffer, the thirteenth switch and the third Miller compensation capacitor are coupled in series between the gate of the first PMOS transistor and the second end of the voltage-voltage feedback network, the fourteenth switch and the fourth Miller compensation capacitor are coupled in series between the gate of the first NMOS transistor and the second end of the voltage-voltage feedback network.

Optionally, the eleventh switch and the thirteenth switch are both PMOS switches; the twelfth switch and the fourteenth switch are both NMOS switches.

Optionally, the non-inverting input terminal of the operational amplifier receives a fixed voltage; the inverting input terminal of the operational amplifier receives the output of the pre-stage circuit and is coupled to the first end of the voltage-voltage feedback network; the voltage-voltage feedback network comprises a first feedback resistor coupled between the first and second ends of the voltage-voltage feedback network.

Optionally, the resistance of the first feedback resistor is equal to the output resistance of the pre-stage circuit.

Optionally, the pre-stage circuit is a resistive DAC; the resistance of the first feedback resistor is equal to the output resistance of the resistive DAC; the value of the fixed voltage is equal to half of the maximum output voltage value of the resistive DAC; and the output voltage of the resistive DAC is an analog voltage obtained by inverting a digital code value inputted to the resistive DAC and quantizing the inverted value.

Optionally, the non-inverting input terminal of the operational amplifier receives the output of the pre-stage circuit; the inverting input terminal of the operational amplifier is coupled to the first end of the voltage-voltage feedback network; the voltage-voltage feedback network comprises a wire or a second feedback resistor, coupled between the first and second ends of the voltage-voltage feedback network.

Optionally, in the case where the voltage-voltage feedback network comprises the second feedback resistor, the voltage-voltage feedback network further comprises a third feedback resistor coupled between the first end of the voltage-voltage feedback network and the ground.

Therefore, the present disclosure can selectively configure different negative feedback loops by controlling the on/off status of two sets of switches when the buffer drives different capacitive loads, and reduce the impact of introduced switches on the negative feedback loop by optimizing the arrangement of these two sets of switches, thereby ensuring that the buffer can stably drive various capacitive loads.

Further, in some embodiments, based on the load condition being driven, which set of these two sets of switches can be selected to be closed, so that there is an isolation resistor or no isolation resistor in the negative feedback loop of the buffer, and the second end of the voltage-voltage feedback network can be coupled through the switch to the output terminal of the buffer instead of the output terminal of the operational amplifier, in the case of no need for isolation resistor, thereby avoiding the existence of resistance between the output of the operational amplifier and the output of the buffer, that is, avoiding increasing the output impedance of the buffer, because in an ideal state, the output impedance of the buffer should be zero.

Further, in some embodiments, some of the switches are putted into the output stage of the operational amplifier and become part of it, which allows the output terminal of the operational amplifier to be directly coupled to different nodes, thereby reducing the impact caused by the switches placed after the output terminal of the operational amplifier. In addition, the switches can be designed to have smaller internal resistances and smaller areas, which are beneficial for the implementation of the buffer disclosed in this disclosure.

Further, the structures of some embodiments can use fewer switches, which further reduces the circuit area of the buffer.

Further, in some embodiments, even in the case of configuring different negative feedback loops to drive different capacitive loads, the Miller compensation capacitors can remain coupled at the current output node of the operational amplifier, providing more accurate Miller compensation. In addition, in some cases, different Miller compensation capacitance values can be used for different capacitive loads, to further improve the stability of the buffer.

According to an embodiment of the present disclosure, an integrated circuit is provided, the integrated circuit comprising: a buffer according to any of the previously described embodiments of the present disclosure. That is to say, all components contained in the buffer according to the aforementioned embodiment are integrated into the same IC chip.

Optionally, the integrated circuit further comprises: a pre-stage circuit whose output terminal is coupled to the buffer, wherein, the pre-stage circuit is a circuit module that can be equivalent to a voltage source with output resistance.

Optionally, the first set of switches and the second set of switches are controlled by at least one signal from outside of the integrated circuit.

Optionally, the first set of switches and the second set of switches are controlled by configuring at least one register bit inside the integrated circuit.

Optionally, the pre-stage circuit is a DAC.

Optionally, the DAC is a resistive DAC.

Therefore, the present disclosure can easily control the on/off of the switches in the buffer within the integrated circuit by various ways like an external signal or register configuration of the integrated circuit depending on the capacitance value of the capacitive load driven by the application, so as to select the negative feedback loop with/without isolation resistor, thereby obtaining a stable negative feedback loop, which has a wide range of applications, is easy to use, and has low cost.

## BRIEF DESCRIPTION OF FIGURES

The above and other objects, features and advantages of the present disclosure will become more apparent from the more detailed description of the exemplary embodiments of the present disclosure taken in conjunction with the accompanying drawings, wherein the same reference numerals generally refer to the same parts in exemplary embodiments of the present disclosure.

Figs. 1A and 1B respectively show schematic diagrams for the principles of buffers according to some embodiments of the present disclosure.

Figs. 2A to 2C respectively show schematic block diagrams of buffers according to some embodiments of the present disclosure, Fig. 2D shows a schematic diagram for the implementation principle of a part of a buffer according to some embodiments of the present disclosure, and Figs. 2E to 2G respectively show schematic block diagrams of buffers according to some embodiments of the present disclosure.

Figs. 3A to 3C respectively illustrate the composition diagrams of buffers according to some embodiments of the present disclosure, including specific switch arrangements.

Figs. 4 to 10 respectively show specific circuit schematic diagrams of buffers according to some embodiments of the present disclosure.

## DETAILED DESCRIPTION

Some embodiments of the present disclosure will be described in more detail below with reference to the accompanying drawings. Although the embodiments of the present disclosure are shown in the drawings, it is understood that the present disclosure may be embodied in various forms and should not be limited to the embodiments set forth herein. Rather, these embodiments are provided so that this disclosure will be thorough and complete, and will fully convey the scope of the disclosure to those skilled in the art.

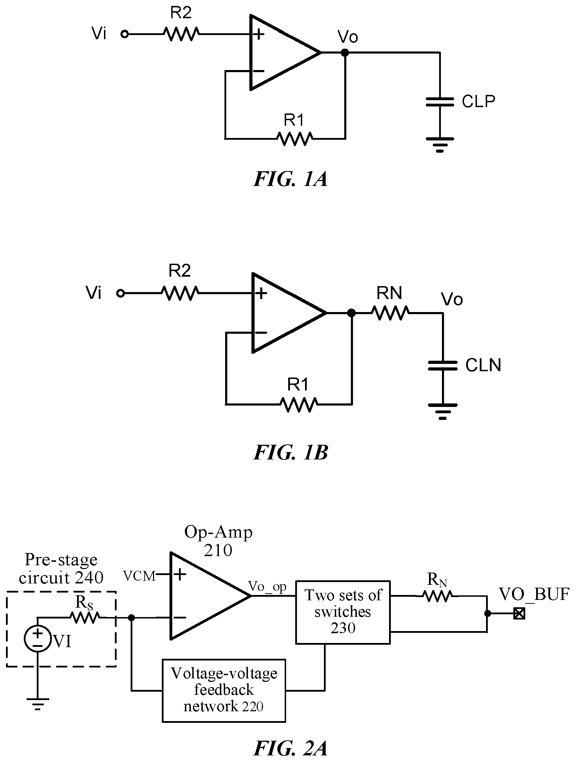

Figs. 1A and 1B respectively illustrate schematic diagrams for the principles of buffers according to some embodiments of the present disclosure, where a specific implementation of a non-inverting input buffer using a voltage-voltage feedback mechanism is taken as an example to illustrate the case of driving different capacitive loads CLP and CLN separately. It is understood that the types of buffers and their connection ways in Figs. 1A and 1B are exemplary only and not restrictive. This disclosure can adopt any suitable buffer structure implemented using a voltage-voltage feedback operational amplifier.

As shown in Figs. 1A and 1B, the buffer includes an operational amplifier and its feedback resistor R1, where the input voltage Vi of the operational amplifier is coupled to the non-inverting input terminal of the operational amplifier through a resistor R2, and the feedback resistor R1 is coupled between the inverting input terminal and the output terminal of the operational amplifier. Thus, the operational amplifier forms a unit gain buffer with a follower structure, and its stability is affected by the capacitance value of the driven capacitive load.

As shown in Fig. 1A, the output terminal Vo of the buffer may directly drive a small load capacitor CLP, such as a small capacitive load with capacitance value in the pF level (such as tens of pF or below 100pF or below hundreds of pF, etc.). In the case of driving the small capacitive load, the output pole can be pushed outside the unit gain bandwidth of the loop by usually using Miller Compensation inside the operational amplifier, such as the Miller compensation capacitor inside the operational amplifier not shown in the figure, making the negative feedback loop stable with sufficient gain margin and phase margin. That is to say, when driving the small capacitive load, the output terminal of the operational amplifier can serve as the output terminal of the buffer, directly coupled to the load, and the stability of the buffer operation can be ensured.

However, when the capacitance value of the driven capacitive load increases to the nF or uF level, the distribution of zeros and poles in the negative feedback loop changes, causing the output poles to fall near or within the unit gain bandwidth of the loop, and the negative feedback loop is no longer stable. Therefore, as shown in Fig. 1B, when the buffer drives a large load capacitor CLN (a large capacitive load, such as a load with a capacitance value of nF or uF level), a large isolation resistor RN may be used for isolation to ensure that the distribution of zeros and poles in the negative feedback loop is not changed and the loop remains stable. However, when driving the small capacitive load, it is desirable for the output impedance of the buffer to approach zero, so it is not desirable for the isolation resistor RN to appear between the output terminal of the operational amplifier and the load capacitor.

Therefore, in order to ensure that the buffer can stably drive various capacitive loads, different negative feedback loops need to be configured according to the capacitance value of the capacitive load.

Therefore, this disclosure proposes a novel structure of buffer that can selectively configure different negative feedback loops by controlling the on/off status of two sets of switches, and reduce the impact of introduced switches on the negative feedback loop by optimizing the arrangement of these two sets of switches, thereby ensuring that the buffer can stably drive various capacitive loads. In addition, in some embodiments, the various components (including the operational amplifier, feedback network, isolation resistor, and switches, etc.) of the buffer may be integrated into the same integrated circuit, and the on/off of the switches in the buffer may be easily controlled by various ways like external signal control or register configuration of the integrated circuit depending on the capacitance value of the capacitive load driven by the application, so as to select the negative feedback loop with/without isolation resistor, thereby obtaining a stable negative feedback loop, which has a wide range of applications, is easy to use, and has low cost.

In some embodiments, the present disclosure proposes a buffer comprising:

an operational amplifier, whose non-inverting or inverting input terminal receives an output of a pre-stage circuit;
a voltage-voltage feedback network for the operational amplifier, whose first end is coupled to the inverting input terminal of the operational amplifier;
an isolation resistor, whose first end is coupled to an output terminal of the buffer; and
a first set of switches and a second set of switches, configured to close the first set of switches and open the second set of switches in the case where the buffer drives a first capacitive load, and to open the first set of switches and close the second set of switches in the case where the buffer drives a second capacitive load, such that:

in the case where the buffer drives the first capacitive load, an output terminal of the operational amplifier is coupled to the output terminal of the buffer via at least one switch in the first set of switches, and a second end of the voltage-voltage feedback network is coupled to the output terminal of the buffer via at least one switch in the first set of switches or directly coupled to a second end of the isolation resistor so that the isolation resistor is used as a feedback resistor for the operational amplifier, and
in the case where the buffer drives the second capacitive load, the output terminal of the operational amplifier is coupled to the second end of the isolation resistor via at least one switch in the second set of switches, and the second end of the voltage-voltage feedback network is coupled to the output terminal of the operational amplifier via at least one switch in the second set of switches.

This disclosure does not limit the coupling way of the operational amplifier and its voltage-voltage feedback network. For example, the operational amplifier may receive the output of the pre-stage circuit at its non-inverting or inverting input terminal, and correspondingly couple the first end of the voltage-voltage feedback network to the inverting input terminal of the operational amplifier, thereby forming a corresponding non-inverting input buffer or inverting input buffer.

In addition, this disclosure does not limit the specific implementation of the voltage-voltage feedback network, as long as it can be coupled between the input and output terminals of the operational amplifier to form corresponding negative feedback. In the embodiments of the present disclosure, the "first" and "second" ends of the voltage-voltage feedback network are named to merely distinguish their coupling positions and not to have other limiting functions, where the first end is directly coupled to one input terminal of the operational amplifier, while the second end is coupled to the output terminal of the operational amplifier through a switch.

In addition, the buffer disclosed herein has a wide range of applications and may be used to connect behind various circuits to improve their driving capabilities. That is to say, this disclosure does not limit the specific structure or function of the pre-stage circuit. For example, as will be detailed in the following figures, the pre-stage circuit may be any circuit module that can be equivalent to a voltage source with output resistance. The following examples will be described using a DAC (Digital to Analog Converter) as an example of the pre-stage circuit (i.e., using the buffer disclosed in this disclosure to improve the driving capability of DAC), but it is understood that this disclosure is not limited to this. In some examples, the DAC may be various types of resistive DACs, such as DACs using T-shaped or inverted T-shaped resistor networks.

In addition, in the disclosed embodiments, the "first" and "second" ends of the isolation resistor are named to merely distinguish their coupling positions and not to have other limiting functions, where the first end is directly coupled to the output terminal of the buffer, while the second end may be coupled to the output terminal of the operational amplifier through a switch or directly coupled to the second end of the voltage-voltage feedback network.

In addition, this disclosure does not limit the specific implementation of the first and second sets of switches, as long as they can be controlled to alternately open and close (i.e., when one set of switches is closed, the other set of switches is open, and vice versa), and to implement the two different coupling ways (i.e., two different negative feedback loops) defined in the aforementioned solutions in two different situations. For example, as will be described later in conjunction with the accompanying figures, based on the load condition being driven, which set of these two sets of switches may be selected to be closed, so that there is an isolation resistor or no isolation resistor in the negative feedback loop of the buffer, and the second end of the voltage-voltage feedback network may be coupled through the switch to the output terminal of the buffer instead of the output terminal of the operational amplifier, in the case of no need for isolation resistor, thereby avoiding the existence of resistance between the output of the operational amplifier and the output of the buffer, that is, avoiding increasing the output impedance of the buffer, because in an ideal state, the output impedance of the buffer should be zero.

Below, some buffer structures according to the embodiments of the present disclosure mentioned before will be discussed in conjunction with the schematic block diagrams in Figs. 2A to 2G. It is understood that although the same reference numerals are used to represent the same components in Figs. 2A to 2G, this does not mean that these components have the same structures or device parameters in the examples of the respective drawings, and instead these components may adopt the same or different structures or device parameters according to the actual situation of each example.

The buffer shown in Fig. 2A is an inverting input buffer, where a non-inverting input terminal of operational amplifier 210 receives a fixed voltage VCM, and an inverting input terminal of operational amplifier 210 receives an output of a pre-stage circuit 240 (equivalent to a voltage source VI + an output resistor RS shown in the dashed box in the figure) and is coupled to a first end of a voltage-voltage feedback network 220. A first end of an isolation resistor RN is coupled to an output terminal VO_BUF of the buffer, and an output terminal Vo_op of operational amplifier 210 may be coupled to a second end of the isolation resistor RN or the output terminal VO_BUF of the buffer via at least one switch in one of two sets of switches 230. A second end of the voltage-voltage feedback network 220 may be coupled to the output terminal Vo_op of operational amplifier 210 or the output terminal VO_BUF of the buffer via at least one switch in one of the two sets of switches 230, thereby selectively configuring the negative feedback loop with or without the isolation resistor, so as to adapt to different load conditions. In addition, in the case that there is no isolation resistor in the negative feedback loop, it is possible to couple the second end of the voltage-voltage feedback network to the output terminal of the buffer rather than the output terminal of the operational amplifier via a switch, thereby avoiding the existence of resistance between the output of the operational amplifier and the output of the buffer, that is, avoiding increasing the output impedance of the buffer, because the ideal output impedance of the buffer should be zero.

In addition, compared to the non-inverting input buffer that will be described later, the inverting input buffer has additional advantage, that is, the input voltages received by the input pair of transistors of the operational amplifier are always the fixed voltage VCM or a feedback voltage that varies around it, which avoids the use of rail-to-rail input operational amplifier (which may require more complex input pair of transistors, such as PMOS and NMOS input pair, and the offsets in PMOS and NMOS input pair are often inconsistent, resulting in larger offset error).

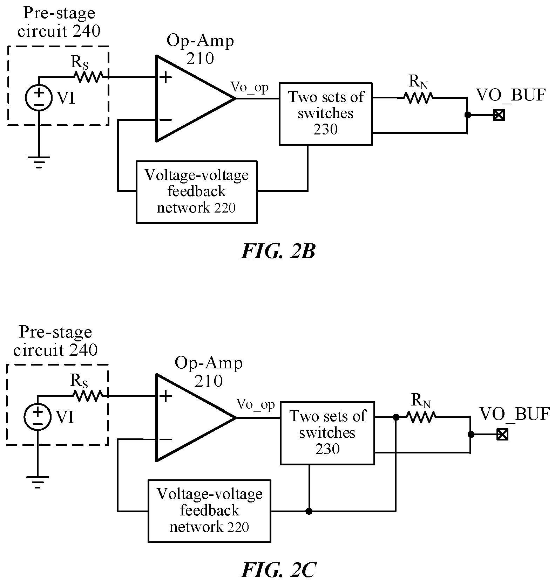

As mentioned earlier, this disclosure does not limit the specific implementation of the voltage-voltage feedback network 220 and the two sets of switches 230, therefore block diagrams are used to represent these two parts in Fig. 2A and subsequent Figs. 2B-2G.

The buffer shown in Fig. 2B is a non-inverting input buffer, which differs from Fig. 2A mainly in that the output of the pre-stage circuit 240 is coupled to the non-inverting input terminal of the operational amplifier 210 instead of the inverting input terminal. The first end of the voltage-voltage feedback network 220 remains coupled to the inverting input terminal of the operational amplifier 210. The remaining coupling ways and the working mode of the switches are the same as those in Fig. 2A mentioned above, and will not be repeated here.

The buffer shown in Fig. 2C is also a non-inverting input buffer, which differs from Fig. 2B mainly in that the second end of the voltage-voltage feedback network 220 is directly coupled to the second end of the isolation resistor RN, and in the case where the negative feedback loop does not require an isolation resistor, that is, the output terminal Vo_op of the operational amplifier 210 is coupled to the output terminal VO_BUF of the buffer through at least one switch, the isolation resistor RN is used as the feedback resistor of the operational amplifier 210. That is to say, the isolation resistor RN in Fig. 2C may be connected in the application circuit of the buffer when the two sets of switches 230 are respectively closed (RN is not in the negative feedback loop when used as an isolation resistor), but when the buffer drives a large capacitive load, RN is used as an isolation resistor to improve stability, while when the buffer drives a small capacitive load, RN becomes a feedback resistor of the operational amplifier 210. The remaining coupling ways and the working mode of the switches are the same as those in Fig. 2B mentioned above, and will not be repeated here.

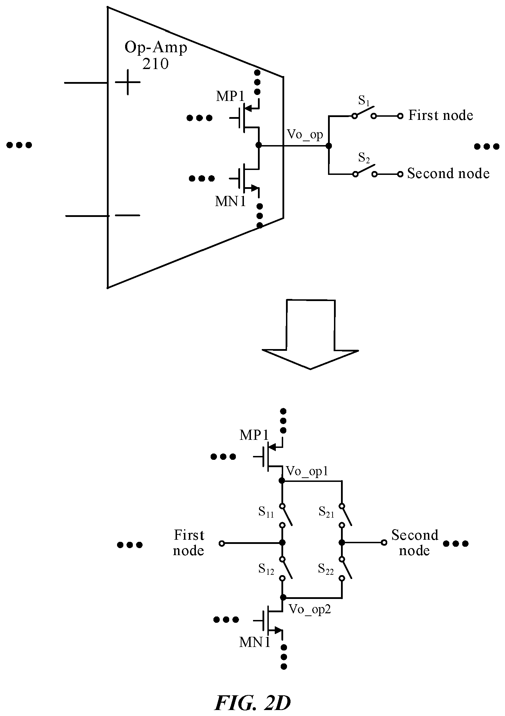

In addition, in order to further optimize the arrangement of switches so as to reduce the impact of introduced switches on the negative feedback loop, in some embodiments, it may be considered to combine at least some switches in the two sets of switches with the last driver amplifier stage (i.e., the output stage) of the operational amplifier, as shown exemplarily in Figs. 2D to 2G below, where Fig. 2D briefly illustrates its principle.

As shown in the upper part of Fig. 2D, the output terminal Vo_op of op amp 210 is usually led out from the connection between the drain of the PMOS transistor (marked by MP1) and the drain of the NMOS transistor (marked by MN1) in its output stage. That is to say, the drain of PMOS transistor MP1 and the drain of NMOS transistor MN1 may both be regarded as the output terminals of op amp 210. As mentioned earlier, in the embodiments of the present disclosure, the output terminal Vo_op of operational amplifier 210 may be coupled to two different nodes (such as the first node and the second node shown in Fig. 2D) respectively through two different switches (identified by S1 and S2), thereby configuring different negative feedback loops.

It is understood that, as mentioned earlier, the embodiments of the present disclosure can adopt various suitable structures for the operational amplifier, the voltage-voltage feedback network and the two sets of switches, therefore, in Fig. 2D, except for the relevant components that need to clarify the principle, the rest of the parts are represented by ellipses.

In addition, it is understood that the output stage of the operational amplifier refers to the stage involved in the output of the operational amplifier, which is usually the last driver amplifier stage of the operational amplifier. If the operational amplifier itself has only one stage, then the output stage is the operational amplifier itself. According to the structure of the output stage, the sources of PMOS transistor MP1 and NMOS transistor MN1 may be connected to the power supply voltage and ground respectively, or may be connected to other PMOS transistor and NMOS transistor respectively, therefore, ellipses are also used in the figure to represent them. In addition, the "first node" and "second node" in the figure are only used to refer to two different nodes, which may be endpoints or intermediate nodes of the various components discussed in Figs. 2A to 2C as needed.

In some embodiments, the arrangement of the switches shown in the upper part of Fig. 2D may be modified and integrated into the output stage of operational amplifier 210, as shown in the lower part of Fig. 2D.

As shown in the lower part of Fig. 2D, two series connected switches S11 and S12 may be inserted between the drain of PMOS transistor MP1 and the drain of NMOS transistor MN1 in the output stage of operational amplifier 210, and the connection between these two series connected switches S11 and S12 is directly coupled to the first node. Similarly, another switch branch, namely another two series connected switches S21 and S22, may be inserted in parallel with the two series connected switches S11 and S12, between the drain of PMOS transistor MP1 and the drain of NMOS transistor MN1. The connection between these two series connected switches S21 and S22 is directly coupled to the second node.

In the case where the switches S11 and S12 are closed and the switches S21 and S22 are open, the output terminal of operational amplifier 210 may be regarded as the connection between the switches S11 and S12, which is directly coupled to the first node. In the case where the switches S11 and S12 are open and the switches S21 and S22 are closed, the output terminal of operational amplifier 210 may be regarded as the connection between the switches S21 and S22, which is directly coupled to the second node.

Compared to the switch arrangement shown in the upper part of Fig. 2D, the switch arrangement shown in the lower part of Fig. 2D may be regarded as putting the switches into the output stage of the operational amplifier and becoming part of it, so as to allow the output terminal of the operational amplifier to be directly coupled to different nodes, thereby reducing the impact caused by the switches placed after the output terminal of the operational amplifier. In addition, in some cases, the switches S1 and S2 shown in the upper part of Fig. 2D are usually implemented by CMOS transmission gates, while the switches S11 and S21 shown in the lower part of Fig. 2D are usually implemented by PMOS transistors, and the switches S12 and S22 are usually implemented by NMOS transistors; thus compared to the switches S1 and S2, it is easier to manufacture the switches S11, S12, S21, and S22 with lower internal resistance and smaller area.

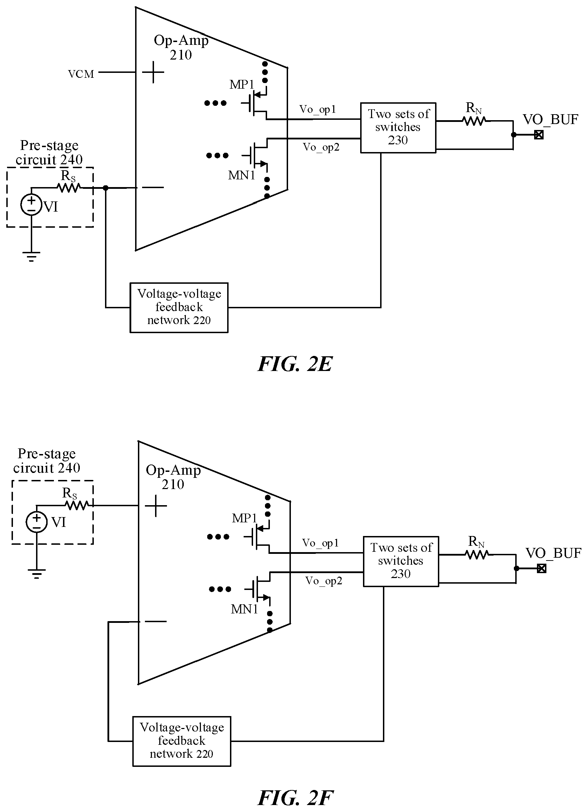

Thus, the buffers in Figs. 2A to 2C may be transformed into the buffers shown in Figs. 2E to 2G, respectively. For ease of description, the switches inserted between the drain of PMOS transistor MP1 and the drain of NMOS transistor MN1 are considered as part of the two sets of switches 230 instead of part of the op amp 210, and the drain of PMOS transistor MP1 and the drain of NMOS transistor MN1 are considered as the output terminals Vo_op1/Vo_op2 of the op amp. The remaining coupling ways and the working mode of the switches are the same as those in Figs. 2A to 2C mentioned above, and will not be repeated here.

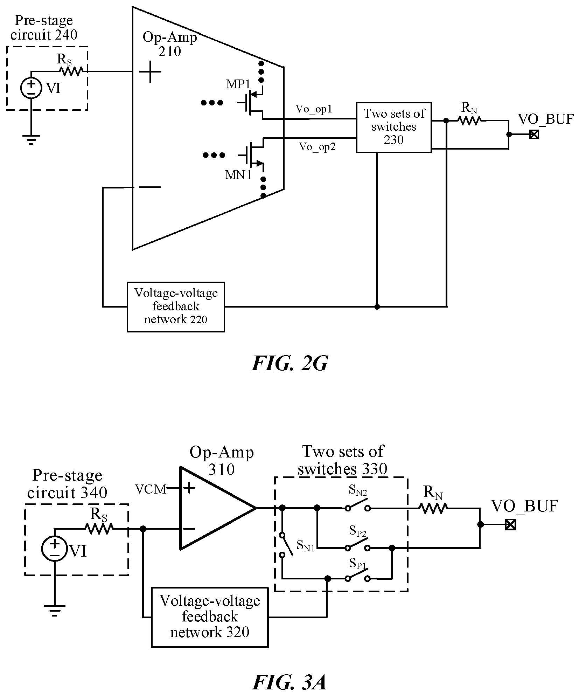

Below, some specific arrangement examples of two sets of switches in a buffer according to some embodiments of the present disclosure will be discussed in conjunction with Figs. 3A to 3C. It is understood that although the same reference numerals are used to represent the same components in Figs. 3A to 3C, this does not mean that these components have the same structure or device parameters in the examples of the respective drawings, and instead these components may adopt the same or different structures or device parameters according to the actual situation of each example. Furthermore, although only specific arrangement examples of two sets of switches for selectively configuring two different loops are provided in the accompanying drawings of this disclosure, it is understood that this disclosure is not limited to those, but can be applied to more sets of switches for selectively configuring more different loops, whose specific implementation can be easily obtained based on the inspiration of this disclosure.

The buffer structure in Fig. 3A corresponds to the structure shown in Fig. 2A, with the only difference being that a specific arrangement example of two sets of switches is provided. However, it is understood that the switch arrangement shown in Fig. 3A is not only applicable to the buffer structure shown in Fig. 2A, but also to various other suitable buffer structures, such as the structure shown in Fig. 2B.

As shown in Fig. 3A, in the two sets of switches 330, the first set of switches includes a first switch SP2 and a second switch SP1, and the second set of switches includes a third switch SN2 and a fourth switch SN1. Among them, the switch SP2 is coupled between the output terminal of the operational amplifier 310 and the output terminal VO_BUF of the buffer, the switch SP1 is coupled between the second end of the voltage-voltage feedback network 320 and the output terminal VO_BUF of the buffer, the switch SN2 is coupled between the output terminal of the operational amplifier 310 and the second end of the isolation resistor RN, and the switch SN1 is coupled between the second end of the voltage-voltage feedback network 320 and the output terminal of the operational amplifier 310. In some examples, the switches SP1, SP2, SN1, and SN2 are all CMOS transmission gate switches.

When driving a first capacitive load (such as a small capacitive load), the first set of switches SP1 and SP2 are closed, and the second set of switches SN1 and SN2 are opened. Thereby the output of operational amplifier 310 reaches the output terminal VO_BUF of the buffer through the switch SP2, and is then fed back to the inverting input terminal through the switch SP1 and the voltage-voltage feedback network 320. When driving a second capacitive load (such as a large capacitive load), the first set of switches SP1 and SP2 are opened, and the second set of switches SN1 and SN2 are closed. Thereby, the output of operational amplifier 310 is negatively fed back to the inverting input terminal through the switch SN1 and the voltage-voltage feedback network 320, and reaches the output terminal VO_BUF of the buffer through the switch SN2 and the isolation resistor RN. At this time, the resistor RN acts as an isolation resistor. Thus, two negative feedback loops of the buffer can be configured separately through the two sets of switches, and the corresponding negative feedback loop can be selected to operate by controlling any one of the two sets of switches to close and the other to open.

In addition, it is understood that each switch has a conduction resistance (also known as the internal resistance of the switch) when conducting. In some cases, the internal resistance of the switch may affect the output of the buffer. Therefore, the switch arrangement disclosed in this disclosure is designed to minimize the impact of the internal resistance of the switch. As shown in Fig. 3A, when driving the first capacitive load, due to usually large driving current of the buffer, that is, the current flowing through the closed switch SP2 is large, the internal resistance of the switch SP2 may cause a large voltage drop across the switch SP2, such as a voltage drop of 0.1V or 1V level, resulting in the operational amplifier not having this driving capability, and ultimately the voltage at VO_BUF is also incorrect (unable to drive). Therefore, in order to avoid inaccurate final output voltage (i.e., the voltage at the output terminal VO_BUF) of the buffer, Fig. 3A couples the second end of the voltage-voltage feedback network 320 to the output terminal VO_BUF of the buffer, instead of the output terminal of the operational amplifier 310, through the switch SP1. At this time, the internal resistance of the closed switch SP1 constitutes a feedback resistor, and compared to the commonly used voltage-voltage feedback network 320, which will be described in detail later, the internal resistance of the switch SP1 is usually set to be smaller, which can be ignored or whose impact on the voltage fed back to the input terminal of the operational amplifier can be ignored compared to the resistance of the feedback network. Therefore, the final output voltage of the buffer can be accurately fed back to the input terminal of the operational amplifier, ensuring that the voltage at the output terminal VO_BUF of the buffer is basically accurate. In addition, when driving the second capacitive load, the internal resistance of the closed switch SN2 may act as an isolation resistor together with the isolation resistor RN, and similarly, the internal resistance of the closed switch SN1 also constitutes a feedback resistor, which is set to be negligible compared to the feedback network resistance, therefore, its impact on the final output voltage of the buffer can also be ignored.

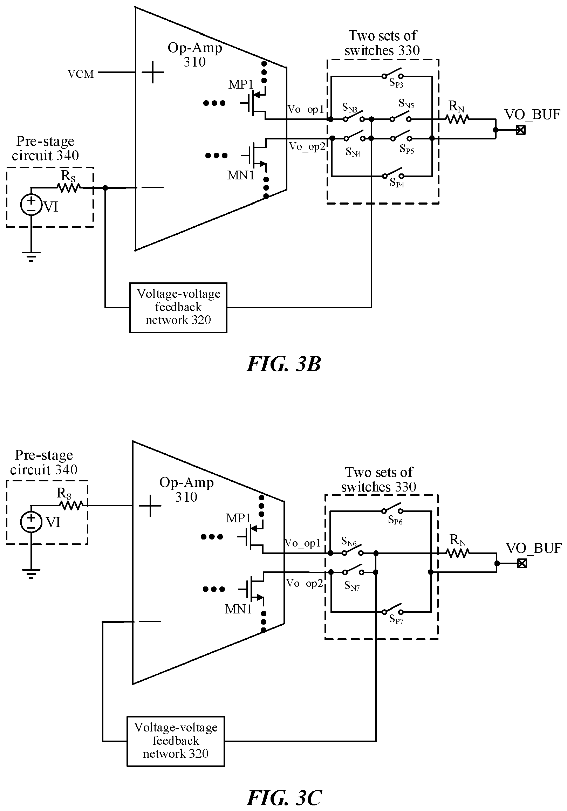

The buffer structure in Fig. 3B corresponds to the structure shown in Fig. 2E, with the only difference being that a specific arrangement example of two sets of switches is provided. However, it is understood that the switch arrangement shown in Fig. 3B is not only applicable to the buffer structure shown in Fig. 2E, but also to various other suitable buffer structures, such as the structure shown in Fig. 2F.

As shown in Fig. 3B, in the two sets of switches 330, the first set of switches includes a fifth switch SP3, a sixth switch SP4, and a seventh switch SP5, and the second set of switches includes an eighth switch SN3, a ninth switch SN4, and a tenth switch SN5. Among them, the switch SP3 is coupled between the drain of PMOS transistor MP1 and the output terminal VO_BUF of the buffer, the switch SP4 is coupled between the drain of NMOS transistor MN1 and the output terminal VO_BUF of the buffer, the switch SP5 is coupled between the second end of the voltage-voltage feedback network 320 and the output terminal VO_BUF of the buffer, the switch SN3 is coupled between the drain of the PMOS transistor MP1 and the second end of the voltage-voltage feedback network 320, the switch SN4 is coupled between the drain of the NMOS transistor MN1 and the second end of the voltage-voltage feedback network 320, and the switch SN5 is coupled between the second end of the voltage-voltage feedback network 320 and the second end of the isolation resistor RN. In some examples, the switches SP3 and SN3 are both PMOS switches, the switches SP4 and SN4 are both NMOS switches, and the switches SP5 and SN5 are both CMOS transmission gate switches. For example, the PMOS switches and the NMOS switches may be implemented by a single PMOS transistor and a single NMOS transistor, respectively.

When driving the small capacitive load, the first set of switches SP3, SP4, and SP5 are closed, the second set of switches SN3, SN4, and SN5 are opened, the transistors MP1 and MN1 in the output stage of the operational amplifier 310 are connected through the switches SP3 and SP4, and the output of the operational amplifier reaches the output terminal VO_BUF of the buffer, which is then fed back to the inverting input terminal through the switch SP5 and voltage-voltage feedback network 320. When driving the large capacitive load, the first set of switches SP3, SP4, and SP5 are opened, and the second set of switches SN3, SN4, and SN5 are closed, the transistors MP1 and MN1 in the output stage of the operational amplifier 310 are connected through the switches SN3 and SN4, and the output of the operational amplifier is negatively fed back to the inverting input terminal through the voltage-voltage feedback network 320, and at the same time, reaches the output terminal VO_BUF of the buffer through the switch SN5 and the isolation resistor RN, where the resistor RN acts as an isolation resistor. Thus, two negative feedback loops of the buffer can be configured separately through the two sets of switches, and the corresponding negative feedback loop can be selected to operate by controlling any one of the two sets of switches to close and the other to open.

Similar to Fig. 3A, the switch arrangement shown in Fig. 3B can also minimize the adverse effect of switch's internal resistance on the output voltage of the buffer. In addition, as mentioned earlier, compared to the switches in Fig. 3A, the switches in Fig. 3B can have smaller internal resistances and smaller areas, which are beneficial for the implementation of the buffer disclosed in this disclosure.

The buffer structure in Fig. 3C corresponds to the structure shown in Fig. 2G, with the only difference being that a specific arrangement example of two sets of switches is provided. However, it is understood that the switch arrangement shown in Fig. 3C is not only applicable to the buffer structure shown in Fig. 2G, but also to various other suitable buffer structures.

As shown in Fig. 3C, the second end of the voltage-voltage feedback network 320 is directly coupled to the second end of the isolation resistor RN. In addition, in the two sets of switches 330, the first set of switches includes a fifteenth switch SP6 and a sixteenth switch SP7, and the second set of switches includes a seventeenth switch SN6 and a eighteenth switch SN7. Among them, the switch SP6 is coupled between the drain of the PMOS transistor MP1 and the output terminal VO_BUF of the buffer, the switch SP7 is coupled between the drain of the NMOS transistor MN1 and the output terminal VO_BUF of the buffer, the switch SN6 is coupled between the drain of the PMOS transistor MP1 and the second end of the voltage-voltage feedback network 320, and the switch SN7 is coupled between the drain of the NMOS transistor MN1 and the second end of the voltage-voltage feedback network 320. In some examples, the switches SP6 and SN6 are both PMOS switches, and the switches SP7 and SN7 are both NMOS switches.

When driving the small capacitive load, the first set of switches SP6 and SP7 are closed, the second set of switches SN6 and SN7 are opened, and the transistors MP1 and MN1 in the output stage of the operational amplifier 310 are connected through the switches SP6 and SP7, so that the output of the operational amplifier reaches the output terminal VO_BUF of the buffer, which is then fed back to the inverting input terminal through the isolation resistor RN and the voltage-voltage feedback network 320. At this time, the resistor RN does not act as the isolation resistor mentioned above, but becomes a feedback resistor on the feedback branch. When driving the large capacitive load, the first set of switches SP6 and SP7 are opened, the second set of switches SN6 and SN7 are closed, and the transistors MP1 and MN1 in the output stage of the operational amplifier 310 are connected through the switches SN6 and SN7, so that the output of the operational amplifier is negatively fed back to the inverting input terminal through the voltage-voltage feedback network 320, and at the same time, reaches the output terminal VO_BUF of the buffer through the isolation resistor RN which acts as an isolation resistor. Thus, two negative feedback loops of the buffer can be configured separately through the two sets of switches, and the corresponding negative feedback loop can be selected to operate by controlling any one of the two sets of switches to close and the other to open. It is understood that in some cases, such as the case that the voltage-voltage feedback network 320, which will be described in detail later, is only a resistor or a wire, when the first set of switches SP6 and SP7 are closed and the resistor RN becomes the feedback resistor, it will not affect the negative feedback operation of the operational amplifier 310. This is because the input impedance of the operational amplifier is very large, and compared to it, the resistance values of the resistor RN and the voltage-voltage feedback network 320 can be ignored, and the voltage fed back to the inverting input terminal is always equal to the output voltage of the operational amplifier.

Compared to the switch arrangement shown in Fig. 3B, the structure of Fig. 3C can reduce the number of switches and further reduce the circuit area of the buffer.

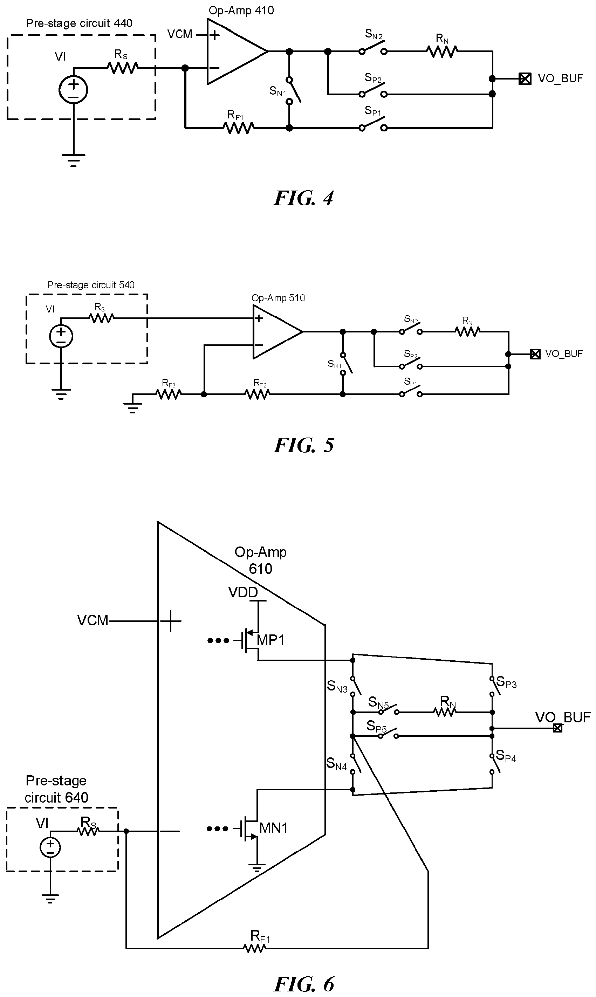

The specific circuit structures of buffers according to some embodiments of the present disclosure will be discussed below in conjunction with Figs. 4 to 10, which provide some specific arrangement examples of the two sets of switches and some specific implementations of the voltage-voltage feedback network. It is understood that although some components are represented by the same reference numerals in Figs. 4 to 10, this does not mean that these components have the same structure or device parameters in the examples of the respective drawings, and instead these components may adopt the same or different structures or device parameters according to the actual situation of each example. In addition, it is understood that in all the figures disclosed herein, different reference numerals are sometimes used to indicate the same or similar components for distinction, but this does not mean that these components have different structures or device parameters from each other, and instead these components may adopt the same or different structures or device parameters according to the actual situation of each example.

The buffer structure in Fig. 4 corresponds to the structure shown in Fig. 3A, with the only difference being that a specific implementation of the voltage-voltage feedback network is provided. However, it is understood that the voltage-voltage feedback network in the embodiments of the present disclosure is not limited to this.

Fig. 4 may also be referred to as an inverting input amplifier, where the voltage-voltage feedback network includes a first feedback resistor RF1 coupled between its first and second ends.

The pre-stage circuit 440 may be, for example, a resistive DAC with an output impedance of *RS* and an output voltage of *Vi.* The buffer disclosed herein is used to improve the driving capability of the DAC, so the output terminal VO_BUF of the buffer may be regarded as the output terminal of the DAC.

The output voltage of the buffer is shown in the following equation:

$$Vo = -\frac{RF1}{RS} * Vi + \frac{(RS+RF1)}{RS} * VCM \ ,$$

where, the output common-mode level is $\frac{(RS+RF1)}{RS} * VCM$ , and the gain is *-RF1/RS.* The gain value of the buffer may be adjusted by the resistance values of the feedback resistor RF1 and the RS. When *RF1=RS,* the gain of the buffer is -1 times. In addition, in some examples, it may set *RF1 = M * RS,* that is, *RF1* is M times RS, resulting in the buffer with M times gain amplification.

The small signal stability analysis of the negative feedback loop in Fig. 4 is the same as the previous analysis combined with Figs. 1A and 1B, with the only difference being the application of large signals.

Therefore, similar to the previous Fig. 3A, the buffer in Fig. 4 can selectively configure the negative feedback loop with or without the isolation resistor in order to adapt to different load conditions, by adding four switches SP1, SP2, SN1, and SN2, which will not be repeated here.

In addition, in some cases where the pre-stage circuit 440 is a resistive DAC, the resistance of the first feedback resistor RF1 may be set to be equal to the resistance of the output resistor RS of the resistive DAC (thus the gain of the buffer is -1 times), the value of the fixed voltage VCM may be set to half of the maximum output voltage Vrf of the resistive DAC, and the output voltage of the resistive DAC (i.e., Vi in Fig. 4) is an analog voltage obtained by inverting the input digital code value and quantizing the inverted value. Thereby, the final output voltage of the buffer is equal to the analog voltage obtained by normal conversion of the digital code value input to the resistive DAC, as follows:

For example, if the resistive DAC is a 12-bit DAC, the input digital code value DACDOR is firstly inverted and then quantized to produce an analog voltage of

$$Vi = (1 - \frac{DACDOR}{4096})Vrf \ ,$$

which is then amplified by the *-1x* inverting amplifier in Fig. 4 (with *VCM=0.5 * Vrf),* and the output large signal is obtained as

$$Vo = -Vi + 2 * VCM = Vrf - Vi = \frac{DACDOR}{4096} Vrf \,.$$

Its advantage lies in the fact that the voltages input to the input pair transistors of the operational amplifier in Fig. 4 are always *Vrf/2* or around it, eliminating the need for an operational amplifier with rail-to-rail input and thus avoiding error caused by inconsistent offset of PMOS and NMOS input pair.

It is understood that this disclosure is not limited to the case of *RF1=RS* discussed above. *RF1=M * RS* may also be set, and the value of M may be selected as needed. At this time, the gain of the buffer is -M times, and thus the following may be similarly set

$$VCM = \frac{RS}{RS+RF1} * Vrf = \frac{1}{1+M} * Vrf \,.$$

The rest of the content may be similarly modified and will not be repeated here.

The buffer structure in Fig. 5 corresponds to the structure shown in Fig. 2B, with the only difference being the adoption of the arrangement of two sets of switches shown in Fig. 3A and the provision of a specific implementation of a voltage-voltage feedback network. However, it is understood that the voltage-voltage feedback network in the embodiments of the present disclosure is not limited to this.

Fig. 5 may also be referred to as a non-inverting input amplifier, where the voltage-voltage feedback network includes a second feedback resistor RF2 coupled between its first and second ends, and a third feedback resistor RF3 coupled between its first end and ground.

The output voltage of the buffer is shown in the following equation:

$$Vo = (1 + \frac{RF2}{RF3}) * Vi \,,$$

where the gain is *1+RF2/RF3*. The gain value of the buffer may be adjusted by the resistance values of the feedback resistors RF2 and RF3. When the value of RF3 is infinite, i.e., it is open-circuit (which may also be regarded as the voltage-voltage feedback network only including the second feedback resistor RF2, similar to the feedback network structure shown in Fig. 1A and Fig. 1B), the buffer is a unit gain buffer with a follower structure, that is, the output voltage of the buffer follows the input voltage Vi.

The small signal stability analysis of the negative feedback loop in Fig. 5 is the same as the previous analysis combined with Figs. 1A and 1B, and the switch arrangement is the same as Fig. 4 and its corresponding content, which will not be repeated here.

The buffer structure in Fig. 6 corresponds to the structure shown in Fig. 3B, with the only difference being that the sources of the transistors MP1 and MN1 in the output stage of the operational amplifier are respectively coupled to the power supply voltage VDD and ground, and the specific implementation of the voltage-voltage feedback network shown in Fig. 4 is adopted.

In some examples, the output stage of the operational amplifier may also be referred to as the last driving amplifier stage of the operational amplifier, and the transistors MP1 and MN1 are the power transistors in the last driving stage of the operational amplifier.

The working principle of the buffer in Fig. 6 is basically the same as that in Fig. 4, with the difference being the arrangement of the two sets of switches.

Similar to those discussed earlier in conjunction with the switch arrangement of Fig. 3B, for the buffer of Fig. 6, when driving the small capacitive load, the first set of switches SP3, SP4, and SP5 are closed, the second set of switches SN3, SN4, and SN5 are open, MP1, SP3, SP4, and MN1 form the rail-to-rail push-pull output stage of the operational amplifier, and the output of the operational amplifier is directly connected to the output of the buffer. At this time, SP5 and RF1 form feedback resistors, and the resistance of SP5 can be ignored compared to RF1. When driving the large capacitive load, the first set of switches SP3, SP4, and SP5 are opened, the second set of switches SN3, SN4, and SN5 are closed, MP1, SN3, SN4, and MN1 form the rail-to-rail push-pull output stage of the operational amplifier, RF1 is a feedback resistor, and the output of the operational amplifier reaches the output terminal VO_BUF of the buffer through the switch SN5 and the isolation resistor RN. At this time, the internal resistance of SN5 also serves as an isolation function (the internal resistance of SN5 may be set as needed, and its size is not limited).

The remaining working principle of the buffer in Fig. 6 will not be elaborated here.

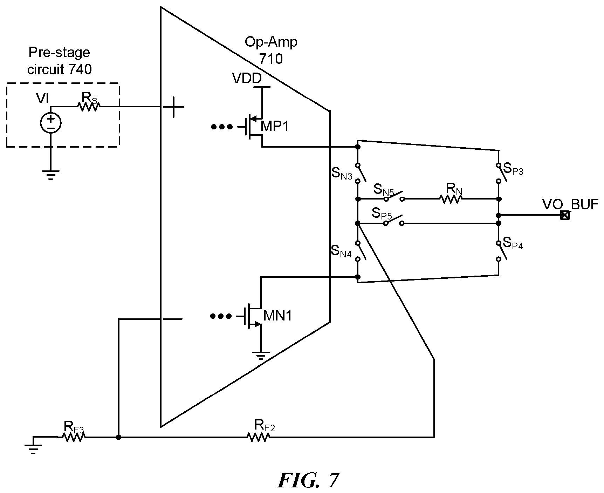

The buffer structure in Fig. 7 corresponds to the structure shown in Fig. 2F, with the only difference being that the sources of the transistors MP1 and MN1 in the output stage (or the last driver amplifier stage of the operational amplifier) of the operational amplifier are respectively coupled to the power supply voltage VDD and ground, and the arrangement of two sets of switches shown in Fig. 3B and the specific implementation of the voltage-voltage feedback network shown in Fig. 5 are adopted.

It is understood that the working principle of the buffer in Fig. 7 is basically the same as that in Fig. 5, with the difference being the arrangement of the two sets of switches. The switch arrangement in Fig. 7 has already been discussed in conjunction with Figs. 3B and 6, and will not be repeated here.

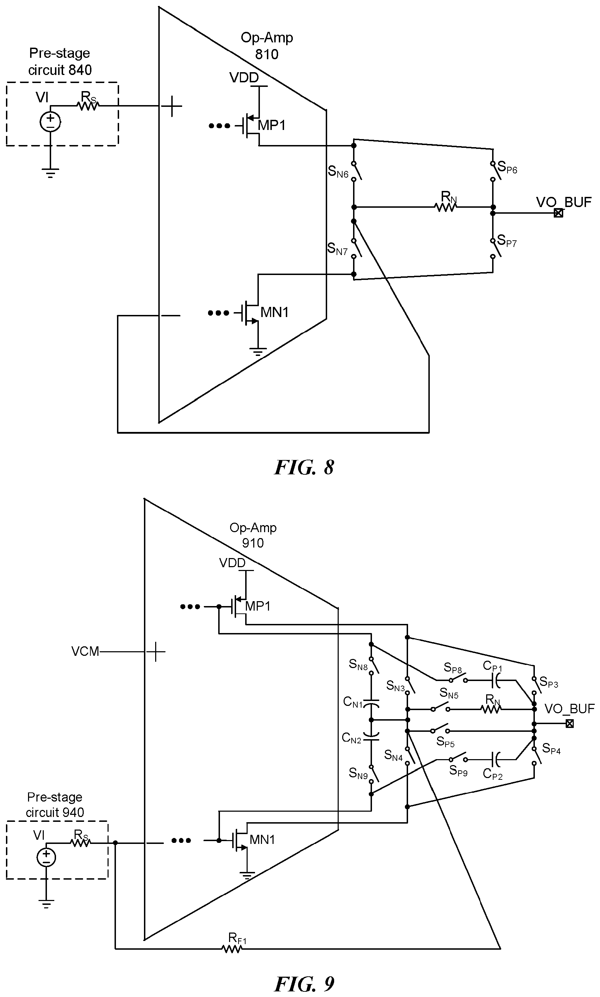

The buffer structure in Fig. 8 corresponds to the structure shown in Fig. 3C mentioned above, with the only difference being that the sources of the transistors MP1 and MN1 in the output stage (which may also be the last driver amplifier stage) of the operational amplifier are respectively coupled to the power supply voltage VDD and ground, and a specific implementation of the voltage-voltage feedback network is provided. However, it is understood that the voltage-voltage feedback network in the embodiments of the present disclosure is not limited to this.

The voltage-voltage feedback network in Fig. 8 may be regarded as a simplified implementation of the voltage-voltage feedback network in Fig. 7, which removes the feedback resistors RF2 and RF3 and only includes a wire coupled between its first and second ends, thus forming a unit gain amplifier with a follower structure, i.e., *Vo=Vi.*

Therefore, the switch arrangement in Fig. 8 removes the switches SN5 and SP5 compared to that in Fig. 7.

Similar to those discussed earlier in conjunction with the switch arrangement of Fig. 3C, for the buffer of Fig. 8, when driving the small capacitive load, the first set of switches SP6 and SP7 are closed, the second set of switches SN6 and SN7 are open, MP1, SP6, SP7, and MN1 form the rail-to-rail push-pull output stage of the operational amplifier, and the output of the operational amplifier is directly connected to the output of the buffer. At this time, the resistor RN forms a feedback resistor on the feedback branch, but it has no effect on the voltage fed back to the input terminal, and Vo is still equal to Vi. When driving the large capacitive load, the first set of switches SP6 and SP7 are opened, the second set of switches SN6 and SN7 are closed, MP1, SN6, SN7, and MN1 form the rail-to-rail push-pull output stage of the operational amplifier, and the output of the operational amplifier reaches the output terminal VO_BUF of the buffer through the isolation resistor RN which acts as an isolation resistor at this time.

The remaining working principle of the buffer in Fig. 8 will not be elaborated here.

In some embodiments, four Miller compensation branches controlled by switches may be added to the buffer structures shown in Figs. 2E to 2G, 3B to 3C, and 6 to 8, respectively, to perform Miller compensation under two capacitive load conditions, further improving the stability of the buffer.

For example, the buffer disclosed herein may further include a first Miller compensation capacitor, a second Miller compensation capacitor, a third Miller compensation capacitor, and a fourth Miller compensation capacitor. The first set of switches may further include an eleventh switch and a twelfth switch, and the second set of switches may further include a thirteenth switch and a fourteenth switch, wherein:

the eleventh switch and the first Miller compensation capacitor are coupled in series between the gate of the first PMOS transistor (MP1) and the output terminal of the buffer,
the twelfth switch and the second Miller compensation capacitor are coupled in series between the gate of the first NMOS transistor (MN1) and the output terminal of the buffer,

the thirteenth switch and the third Miller compensation capacitor are coupled in series between the gate of the first PMOS transistor (MP1) and the second end of the voltage-voltage feedback network,
the fourteenth switch and the fourth Miller compensation capacitor are coupled in series between the gate of the first NMOS transistor (MN1) and the second end of the voltage-voltage feedback network.

In some cases, the eleventh and thirteenth switches are both PMOS switches, while the twelfth and fourteenth switches are both NMOS switches.

Therefore, in the case of driving different capacitive loads, the coupling position of the Miller compensation capacitor can also vary with the output position of the operational amplifier, providing more accurate Miller compensation. In addition, in some cases, different Miller compensation capacitance values may be used for different capacitive loads, to further improve the stability of the buffer. That is to say, the capacitance values of the first Miller compensation capacitor and the third Miller compensation capacitor mentioned above may be different, and the capacitance values of the second Miller compensation capacitor and the fourth Miller compensation capacitor may also be different.

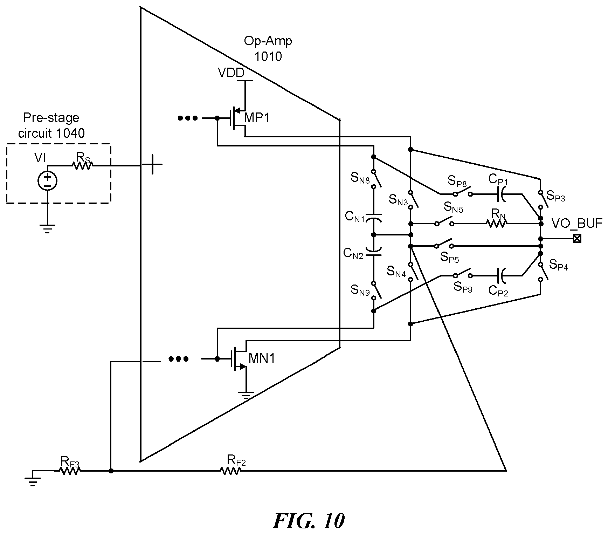

Below, examples of buffers with the added four controllable Miller compensation capacitors according to some embodiments of the present disclosure will be described in conjunction with Figs. 9 and 10.

The buffer structure in Fig. 9 corresponds to the structure shown in Fig. 6, with the only difference being the addition of four controllable Miller compensation capacitors. However, it is understood that the arrangement of these four controllable Miller compensation capacitors is not only applicable to the buffer structure shown in Fig. 6, but can also be applied to various other types of buffer structures.

As shown in Fig. 9, on the basis of the buffer structure shown in Fig. 6, the following has been added:

a switch SP8 and a Miller compensation capacitor CP1, coupled in series between the gate of the PMOS transistor MP1 and the output terminal VO_BUF of the buffer,
a switch SP9 and a Miller compensation capacitor CP2, coupled in series between the gate of the NMOS transistor MN1 and the output terminal VO_BUF of the buffer,
a switch SN8 and a Miller compensation capacitor CN1, coupled in series between the gate of the PMOS transistor MP1 and one end of the feedback resistor RF1,
a switch SN9 and a Miller compensation capacitor CN2, coupled in series between the gate of the NMOS transistor MN1 and the one end of the feedback resistor RF1.

When driving the small capacitive load, the switches SP8 and SP9 are closed, the switches SN8 and SN9 are opened, and the capacitors CP1 and CP2 respectively form Miller compensation capacitors between the current output node of the operational amplifier (also the output node of the buffer) and the gates of the respective output transistors. When driving the large capacitive load, the switches SP8 and SP9 are opened, the switches SN8 and SN9 are closed, and the capacitors CN1 and CN2 respectively form Miller compensation capacitors between the current output node of the operational amplifier (also one end of the voltage-voltage feedback network) and the gates of the respective output transistors.

Therefore, even in the case of configuring different negative feedback loops to drive different capacitive loads, the Miller compensation capacitors can remain coupled at the current output node of the operational amplifier, providing more accurate Miller compensation. In addition, as mentioned earlier, in some examples, in order to further improve the stability of the buffer, different Miller compensation capacitance values may be designed for different negative feedback loops. For example, the capacitance values of the capacitors CP1 and CN1 may be different, and the capacitance values of the capacitors CP2 and CN2 may also be different.

The buffer structure in Fig. 10 corresponds to the structure shown in Fig. 7, with the only difference being the addition of the four controllable Miller compensation capacitors as shown in Fig. 9. Therefore, the working principle of Fig. 10 may refer to the contents of Figs. 7 and 9 mentioned above, and will not be repeated here.

In addition, in some embodiments, all components included in the buffer disclosed herein may be integrated into the same integrated circuit (IC) chip. That is to say, the embodiments of the present disclosure provide an integrated circuit comprising the buffer of any of the aforementioned embodiments of the present disclosure.

In some cases, the integrated circuit may further include a pre-stage circuit whose output terminal is coupled to the buffer. That is to say, the pre-stage circuit and the buffer are integrated into the same IC chip. The pre-stage circuit may be a circuit module that can be equivalent to a voltage source with output resistance.

In addition, in some cases, the first and second sets of switches in the buffer within the integrated circuit are controlled by at least one signal from outside of the integrated circuit, or by configuring at least one register bit inside the integrated circuit.

For example, the output terminal VO_BUF of the buffer may be used as an external terminal (pad) of the IC chip, and according to the capacitance value of the capacitive load externally connected to this IC chip terminal, the appropriate negative feedback loop may be configured by controlling which of the two sets of switches is closed. A control signal may be used to control the on/off of the two sets of switches, for example, the control terminals of the first set of switches receive the control signal, while the control terminals of the second set of switches receive the inverted signal of the control signal. The control signal may be directly received from outside the IC chip, or generated by configuring a register inside the IC chip.

For example, all components contained in the buffer may be integrated into a MCU (Micro Controller Unit) chip, and the first and second sets of switches are controlled by configuring at least one register bit in the MCU chip. In addition, the pre-stage circuit (such as a resistive DAC) may be integrated with the buffer in the MCU chip. Thus, it is easy to configure the negative feedback loop of the buffer as needed to ensure the stability of the buffer.

Various embodiments of the present disclosure have been described above, and the foregoing descriptions are exemplary, not exhaustive, and not limiting of the disclosed embodiments. Numerous modifications and variations will be apparent to those of ordinary skill in the art without departing from the scope of the described embodiments. The terminology used herein was chosen to best explain the principles of the various embodiments, the practical application or improvement over the technology in the marketplace, or to enable others of ordinary skill in the art to understand the various embodiments disclosed herein.

**Claims**

1. A buffer comprising:

   an operational amplifier (210), whose non-inverting or inverting input terminal is configured to receive an output J of a pre-stage circuit (240) external to the buffer;
   a voltage-voltage feedback network (220) for the operational amplifier, whose first end is coupled to the inverting input terminal of the operational amplifier;
   wherein the buffer further comprises:

   an isolation resistor (RN), whose first end is coupled to an output terminal (VO_BUF) of the buffer; and
   a first set of switches and a second set of switches (230), configured to close the first set of switches (SP2+SP1; SP3+SP4+SP5; SP6+SP7; SP3+SP4+SP5+SP8+SP9) and open the second set of switches (SN2+SN1; SN3+SN4+SN5; SN6+SN7; SN3+SN4+SN5+SN8+SN9) in the case where the buffer drives a first capacitive load (CLP), and to open the first set of switches and close the second set of switches in the case where the buffer drives a second capacitive load (CLN), such that:

in the case where the buffer drives the first capacitive load, an output terminal (Vo_op, Vo_op1, Vo_op2) of the operational amplifier is coupled to the output terminal of the buffer via a first subset of switches (SP2; SP3+SP4; SP6+SP7) of the first set of switches, and a second end of the voltage-voltage feedback network is coupled to the output terminal of the buffer via a second subset of switches (SP1; SP5) of the first set of switches or directly coupled to a second end of the isolation resistor so that the isolation resistor is used as a feedback resistor for the operational amplifier, and

in the case where the buffer drives the second capacitive load, the output terminal of the operational amplifier is coupled to the second end of the isolation resistor via a third subset of switches (SN2; SN3+SN4+SN5; SN6+SN7) of the second set of switches, and the second end of the voltage-voltage feedback network is coupled to the output terminal of the operational amplifier via a fourth subset of switches (SN1; SN3+SN4; SN6+SN7) of the second set of switches,

wherein the first subset, the second subset, the third subset and the fourth subset each comprise at least one switch, and the first subset and the second subset are not identical,

wherein the third subset (SN6+SN7) and the fourth subset (SN6+SN7) are identical in the case where the second end of the voltage-voltage feedback network is directly coupled to the second end of the isolation resistor, and the third subset (SN2; SN3+SN4+SN5) and the fourth subset (SN1; SN3+SN4) are not identical in the case where the second end of the voltage-voltage feedback network is not directly coupled to the second end of the isolation resistor,

wherein the capacitance value of the second capacitive load is different from that of the first capacitive load.

2. The buffer according to claim 1, wherein, the capacitance value of the second capacitive load is greater than that of the first capacitive load.

3. The buffer according to claim 1 or 2, wherein,

the first set of switches includes a first switch (SP2) and a second switch (SP1), the second set of switches includes a third switch (SN2) and a fourth switch (SN1), wherein, the first switch is coupled between the output terminal of the operational amplifier and the output terminal of the buffer, and the second switch is coupled between the second end of the voltage-voltage feedback network and the output terminal of the buffer, and the third switch is coupled between the output terminal of the operational amplifier and the second end of the isolation resistor, and the fourth switch is coupled between the second end of the voltage-voltage feedback network and the output terminal of the operational amplifier,

preferably, the first switch, the second switch, the third switch, and the fourth switch are all CMOS transmission gates.

4. The buffer according to claim 1 or 2, wherein,

an output stage of the operational amplifier includes a first PMOS transistor (MP1) and a first NMOS transistor (MN1), wherein a drain of the first PMOS transistor and a drain of the first NMOS transistor are used as the output terminals of the operational amplifier;

the first set of switches includes a fifth switch (SP3), a sixth switch (SP4), and a seventh switch (SP5),

the second set of switches includes an eighth switch (SN3), a ninth switch (SN4), and a tenth switch (SN5),

wherein, the fifth switch is coupled between the drain of the first PMOS transistor and the output terminal of the buffer, the sixth switch is coupled between the drain of the first NMOS transistor and the output terminal of the buffer, and the seventh switch is coupled between the second end of the voltage-voltage feedback network and the output terminal of the buffer,

the eighth switch is coupled between the drain of the first PMOS transistor and the second end of the voltage-voltage feedback network, the ninth switch is coupled between the drain of the first NMOS transistor and the second end of the voltage-voltage feedback network, and the tenth switch is coupled between the second end of the voltage-voltage feedback network and the second end of the isolation resistor.

5. The buffer according to claim 4, wherein,

the fifth switch and the eighth switch are both PMOS switches;
the sixth switch and the ninth switch are both NMOS switches;
the seventh switch and the tenth switch are both CMOS transmission gates.

6. The buffer according to claim 1, wherein,

an output stage of the operational amplifier includes a first PMOS transistor (MP1) and a first NMOS transistor (MN1), wherein a drain of the first PMOS transistor and a drain of the first NMOS transistor are used as the output terminals of the operational amplifier;
the first set of switches includes a fifteenth switch (SP6) and a sixteenth switch (SP7),
the second set of switches includes a seventeenth switch (SN6) and an eighteenth switch (SN7), wherein the second end of the voltage-voltage feedback network is directly coupled to the second end of the isolation resistor,
the fifteenth switch is coupled between the drain of the first PMOS transistor and the output terminal of the buffer, and the sixteenth switch is coupled between the drain of the first NMOS transistor and the output terminal of the buffer,
the seventeenth switch is coupled between the drain of the first PMOS transistor and the second end of the voltage-voltage feedback network, and the eighteenth switch is coupled between the drain of the first NMOS transistor and the second end of the voltage-voltage feedback network.

7. The buffer according to claim 6, wherein,

the fifteenth switch and the seventeenth switch are both PMOS switches;
the sixteenth switch and the eighteenth switch are both NMOS switches.

8. The buffer according to any one of claims 4-7, wherein,

the buffer further comprises a first Miller compensation capacitor (CP1), a second Miller compensation capacitor (CP2), a third Miller compensation capacitor (CN1), and a fourth Miller compensation capacitor (CN2);
the first set of switches further includes an eleventh switch (SP8) and a twelfth switch (SP9);
the second set of switches further includes a thirteenth switch (SN8) and a fourteenth switch (SN9);
wherein the eleventh switch and the first Miller compensation capacitor are coupled in series between a gate of the first PMOS transistor and the output terminal of the buffer,

the twelfth switch and the second Miller compensation capacitor are coupled in series between a gate of the first NMOS transistor and the output terminal of the buffer,
the thirteenth switch and the third Miller compensation capacitor are coupled in series between the gate of the first PMOS transistor and the second end of the voltage-voltage feedback network,
the fourteenth switch and the fourth Miller compensation capacitor are coupled in series between the gate of the first NMOS transistor and the second end of the voltage-voltage feedback network.

9. The buffer according to claim 8, wherein,

the eleventh switch and the thirteenth switch are both PMOS switches;
the twelfth switch and the fourteenth switch are both NMOS switches.

10. The buffer according to any one of claims 1-9, wherein,

the non-inverting input terminal of the operational amplifier receives a fixed voltage (VCM);
the inverting input terminal of the operational amplifier receives the output of the pre-stage circuit and is coupled to the first end of the voltage-voltage feedback network;
the voltage-voltage feedback network comprises a first feedback resistor (RF1) coupled between the first and second ends of the voltage-voltage feedback network,
preferably, the resistance of the first feedback resistor is equal to the output resistance of the pre-stage circuit.

11. The buffer according to claim 10, wherein,

the pre-stage circuit is a resistive DAC;
the resistance of the first feedback resistor is equal to the output resistance of the resistive DAC;
the value of the fixed voltage is equal to half of the maximum output voltage value of the resistive DAC; and
the output voltage of the resistive DAC is an analog voltage obtained by inverting a digital code value inputted to the resistive DAC and quantizing the inverted value.

12. The buffer according to any one of claims 1-9, wherein,

the non-inverting input terminal of the operational amplifier receives the output of the pre-stage circuit;

the inverting input terminal of the operational amplifier is coupled to the first end of the voltage-voltage feedback network;

the voltage-voltage feedback network comprises a wire or a second feedback resistor (RF2), coupled between the first and second ends of the voltage-voltage feedback network, preferably, in the case where the voltage-voltage feedback network comprises the second feedback resistor, the voltage-voltage feedback network further comprises a third feedback resistor (RF3) coupled between the first end of the voltage-voltage feedback network and the ground.

13. An integrated circuit comprising:
a buffer according to any one of claims 1-12.

14. The integrated circuit according to claim 13, further comprising:

a pre-stage circuit, whose output terminal is coupled to the buffer,

wherein, the pre-stage circuit is a circuit module that can be equivalent to a voltage source (VI) with output resistance.

15. The integrated circuit according to claim 13 or 14, wherein,

the first set of switches and the second set of switches are controlled by at least one signal from outside of the integrated circuit; or the first set of switches and the second set of switches are controlled by configuring at least one register bit inside the integrated circuit.

**Patentansprüche**

1. Puffer, umfassend:

einen Operationsverstärker (210), dessen nichtinvertierender oder invertierender Eingangsanschluss konfiguriert ist, um eine Ausgabe einer Vorstufenschaltung (240) außerhalb des Puffers zu empfangen;
ein Spannungs-Spannungs-Rückkopplungsnetzwerk (220) für den Operationsverstärker, dessen erstes Ende mit dem invertierenden Eingangsanschluss des Operationsverstärkers gekoppelt ist;
wobei der Puffer ferner Folgendes umfasst:

einen Isolationswiderstand (RN), dessen erstes Ende mit einem Ausgangsanschluss (VO_BUF) des Puffers gekoppelt ist; und

einen ersten Satz von Schaltern und einen zweiten Satz von Schaltern (230), die konfiguriert sind, um den ersten Satz von Schaltern (SP2+SP1; SP3+SP4+SP5; SP6+SP7; SP3+SP4+SP5+SP8+SP9) zu schließen und den zweiten Satz von Schaltern (SN2+SN1; SN3+SN4+SN5; SN6+SN7; SN3+SN4+SN5+SN8+SN9) zu öffnen, falls der Puffer eine erste kapazitive Last (CLP) treibt, und um den ersten Satz von Schaltern zu öffnen und den zweiten Satz von Schaltern zu schließen, falls der Puffer eine zweite kapazitive Last (CLN) treibt, sodass:

falls der Puffer die erste kapazitive Last treibt, ein Ausgangsanschluss (Vo_op, Vo_op1, Vo_op2) des Operationsverstärkers über einen ersten Teilsatz von Schaltern (SP2; SP3+SP4; SP6+SP7) des ersten Satzes von Schaltern mit dem Ausgangsanschluss des Puffers gekoppelt ist, und ein zweites Ende des Spannungs-Spannungs-Rückkopplungsnetzwerks über einen zweiten Teilsatz von Schaltern (SP1; SP5) des ersten Satzes von Schaltern mit dem Ausgangsanschluss des Puffers gekoppelt ist oder direkt mit einem zweiten Ende des Isolationswiderstands gekoppelt ist, sodass der Isolationswiderstand als Rückkopplungswiderstand für den Operationsverstärker verwendet wird, und
falls der Puffer die zweite kapazitive Last treibt, der Ausgangsanschluss des Operationsverstärkers über einen dritten Teilsatz von Schaltern (SN2; SN3+SN4+SN5; SN6+SN7) des zweiten Satzes von Schaltern mit dem zweiten Ende des Isolationswiderstands gekoppelt ist, und das zweite Ende des Spannungs-Spannungs-Rückkopplungsnetzwerks über einen vierten Teilsatz von Schaltern (SN1; SN3+SN4; SN6+SN7) des zweiten Satzes von Schaltern mit dem Ausgangsanschluss des Operationsverstärkers gekoppelt ist,
wobei der erste Teilsatz, der zweite Teilsatz, der dritte Teilsatz und der vierte Teilsatz jeweils mindestens einen Schalter umfassen, und der erste Teilsatz und der zweite Teilsatz nicht identisch sind,
wobei der dritte Teilsatz (SN6+SN7) und der vierte Teilsatz (SN6+SN7) identisch sind, falls das zweite Ende des Spannungs-Spannungs-Rückkopplungsnetzwerks direkt mit dem zweiten Ende des Isolationswiderstands gekoppelt ist, und der dritte Teilsatz (SN2; SN3+SN4+SN5) und der vierte Teilsatz (SN1; SN3+SN4) nicht identisch sind, falls das zweite Ende des Spannungs-Spannungs-Rückkopplungsnetzwerks nicht direkt mit dem zweiten Ende des Isolationswiderstands gekoppelt ist,

wobei der Kapazitätswert der zweiten kapazitiven Last von demjenigen der ersten kapazitiven Last verschieden ist.

2. Puffer nach Anspruch 1, wobei der Kapazitätswert der zweiten kapazitiven Last größer als derjenige der ersten kapazitiven Last ist.

3. Puffer nach Anspruch 1 oder 2, wobei

der erste Satz von Schaltern einen ersten Schalter (SP2) und einen zweiten Schalter (SP1) umfasst, der zweite Satz von Schaltern einen dritten Schalter (SN2) und einen vierten Schalter (SN1) umfasst, wobei der erste Schalter zwischen dem Ausgangsanschluss des Operationsverstärkers und dem Ausgangsanschluss des Puffers gekoppelt ist, und der zweite Schalter zwischen dem zweiten Ende des Spannungs-Spannungs-Rückkopplungsnetzwerks und dem Ausgangsanschluss des Puffers gekoppelt ist, und

der dritte Schalter zwischen dem Ausgangsanschluss des Operationsverstärkers und dem zweiten Ende des Isolationswiderstands gekoppelt ist, und der vierte Schalter zwischen dem zweiten Ende des Spannungs-Spannungs-Rückkopplungsnetzwerks und dem Ausgangsanschluss des Operationsverstärkers gekoppelt ist,

wobei vorzugsweise der erste Schalter, der zweite Schalter, der dritte Schalter und der vierte Schalter alle CMOS-Übertragungsgatter sind.

4. Puffer nach Anspruch 1 oder 2, wobei

eine Ausgangsstufe des Operationsverstärkers einen ersten PMOS-Transistor (MP1) und einen ersten NMOS-Transistor (MN1) umfasst, wobei ein Drain des ersten PMOS-Transistors und ein Drain des ersten NMOS-Transistors als die Ausgangsanschlüsse des Operationsverstärkers verwendet werden; der erste Satz von Schaltern einen fünften Schalter (SP3), einen sechsten Schalter (SP4) und einen siebten Schalter (SP5) umfasst,

der zweite Satz von Schaltern einen achten Schalter (SN3), einen neunten Schalter (SN4) und einen zehnten Schalter (SN5) umfasst, wobei der fünfte Schalter zwischen dem Drain des ersten PMOS-Transistors und dem Ausgangsanschluss des Puffers gekoppelt ist, der sechste Schalter zwischen dem Drain des ersten NMOS-Transistors und dem Ausgangsanschluss des Puffers gekoppelt ist, und der siebte Schalter zwischen dem zweiten Ende des Spannungs-Spannungs-Rückkopplungsnetzwerks und dem Ausgangsanschluss des Puffers gekoppelt ist,

der achte Schalter zwischen dem Drain des ersten PMOS-Transistors und dem zweiten Ende des Spannungs-Spannungs-Rückkopplungsnetzwerks gekoppelt ist, der neunte Schalter zwischen dem Drain des ersten NMOS-Transistors und dem zweiten Ende des Spannungs-Spannungs-Rückkopplungsnetzwerks gekoppelt ist, und der zehnte Schalter zwischen dem zweiten Ende des Spannungs-Spannungs-Rückkopplungsnetzwerks und dem zweiten Ende des Isolationswiderstands gekoppelt ist.

5. Puffer nach Anspruch 4, wobei

der fünfte Schalter und der achte Schalter beide PMOS-Schalter sind;
der sechste Schalter und der neunte Schalter beide NMOS-Schalter sind;
der siebte Schalter und der zehnte Schalter beide CMOS-Übertragungsgatter sind.

6. Puffer nach Anspruch 1, wobei

eine Ausgangsstufe des Operationsverstärkers einen ersten PMOS-Transistor (MP1) und einen ersten NMOS-Transistor (MN1) umfasst, wobei ein Drain des ersten PMOS-Transistors und ein Drain des ersten NMOS-Transistors als die Ausgangsanschlüsse des Operationsverstärkers verwendet werden;
der erste Satz von Schaltern einen fünfzehnten Schalter (SP6) und einen sechzehnten Schalter (SP7) umfasst,
der zweite Satz von Schaltern einen siebzehnten Schalter (SN6) und einen achtzehnten Schalter (SN7) umfasst,
wobei das zweite Ende des Spannungs-Spannungs-Rückkopplungsnetzwerks direkt mit dem zweiten Ende des Isolationswiderstands gekoppelt ist,
der fünfzehnte Schalter zwischen dem Drain des ersten PMOS-Transistors und dem Ausgangsanschluss des Puffers gekoppelt ist, und der sechzehnte Schalter zwischen dem Drain des ersten NMOS-Transistors und dem Ausgangsanschluss des Puffers gekoppelt ist, der siebzehnte Schalter zwischen dem Drain des ersten PMOS-Transistors und dem zweiten Ende des Spannungs-Spannungs-Rückkopplungsnetzwerks gekoppelt ist, und der achtzehnte Schalter zwischen dem Drain des ersten NMOS-Transistors und dem zweiten Ende des Spannungs-Spannungs-Rückkopplungsnetzwerks gekoppelt ist.

7. Puffer nach Anspruch 6, wobei

der fünfzehnte Schalter und der siebzehnte Schalter beide PMOS-Schalter sind; der sechzehnte Schalter und der achtzehnte Schalter beide NMOS-Schalter sind.

8. Puffer nach einem der Ansprüche 4 bis 7, wobei

der Puffer ferner einen ersten Miller-Kompensationskondensator (CP1), einen zweiten Miller-Kompensationskondensator (CP2), einen dritten Miller-Kompensationskondensator (CN1) und einen vierten Miller-Kompensationskondensator (CN2) umfasst; der erste Satz von Schaltern ferner einen elften Schalter (SP8) und einen zwölften Schalter (SP9) umfasst; der zweite Satz von Schaltern ferner einen dreizehnten Schalter (SN8) und einen vierzehnten Schalter (SN9) umfasst; wobei der elfte Schalter und der erste Miller-Kompensationskondensator in Reihe zwischen einem Gate des ersten PMOS-Transistors und dem Ausgangsanschluss des Puffers gekoppelt sind, der zwölfte Schalter und der zweite Miller-Kompensationskondensator in Reihe zwischen einem Gate des ersten NMOS-Transistors und dem Ausgangsanschluss des Puffers gekoppelt sind, der dreizehnte Schalter und der dritte Miller-Kompensationskondensator in Reihe zwischen dem Gate des ersten PMOS-Transistors und dem zweiten Ende des Spannungs-Spannungs-Rückkopplungsnetzwerks gekoppelt sind, der vierzehnte Schalter und der vierte Miller-Kompensationskondensator in Reihe zwischen dem Gate des ersten NMOS-Transistors und dem zweiten Ende des Spannungs-Spannungs-Rückkopplungsnetzwerks gekoppelt sind.

9. Puffer nach Anspruch 8, wobei

der elfte Schalter und der dreizehnte Schalter beide PMOS-Schalter sind; der zwölfte Schalter und der vierzehnte Schalter beide NMOS-Schalter sind.

10. Puffer nach einem der Ansprüche 1 bis 9, wobei

der nichtinvertierende Eingangsanschluss des Operationsverstärkers eine feste Spannung (VCM) empfängt; der invertierende Eingangsanschluss des Operationsverstärkers die Ausgabe der Vorstufenschaltung empfängt und mit dem ersten Ende des Spannungs-Spannungs-Rückkopplungsnetzwerks gekoppelt ist; das Spannungs-Spannungs-Rückkopplungsnetzwerk einen ersten Rückkopplungswiderstand (RF1) umfasst, der zwischen dem ersten und dem zweiten Ende des Spannungs-Spannungs-Rückkopplungsnetzwerks gekoppelt ist, wobei vorzugsweise der Widerstand des ersten Rückkopplungswiderstands gleich dem Ausgangswiderstand der Vorstufenschaltung ist.

11. Puffer nach Anspruch 10, wobei

die Vorstufenschaltung ein resistiver DAC ist; der Widerstand des ersten Rückkopplungswiderstands gleich dem Ausgangswiderstand des resistiven DAC ist; der Wert der festen Spannung gleich der Hälfte des maximalen Ausgangsspannungswerts des resistiven DAC ist; und die Ausgangsspannung des resistiven DAC eine analoge Spannung ist, die durch Invertieren eines in den resistiven DAC eingegebenen digitalen Codewerts und Quantisieren des invertierten Werts erhalten wird.

12. Puffer nach einem der Ansprüche 1 bis 9, wobei

der nichtinvertierende Eingangsanschluss des Operationsverstärkers die Ausgabe der Vorstufenschaltung empfängt; der invertierende Eingangsanschluss des Operationsverstärkers mit dem ersten Ende des Spannungs-Spannungs-Rückkopplungsnetzwerks gekoppelt ist; das Spannungs-Spannungs-Rückkopplungsnetzwerk einen Draht oder einen zweiten Rückkopplungswiderstand (RF2) umfasst, der zwischen dem ersten und dem zweiten Ende des Spannungs-Spannungs-Rückkopplungsnetzwerks gekoppelt ist, wobei vorzugsweise, falls das Spannungs-Spannungs-Rückkopplungsnetzwerk den zweiten Rückkopplungswiderstand umfasst, das Spannungs-Spannungs-Rückkopplungsnetzwerk ferner einen dritten Rückkopplungswiderstand (RF3) umfasst, der zwischen dem ersten Ende des Spannungs-Spannungs-Rückkopplungsnetzwerks und der Masse gekoppelt ist.

13. Integrierte Schaltung, umfassend:
    einen Puffer nach einem der Ansprüche 1 bis 12.

14. Integrierte Schaltung nach Anspruch 13, ferner umfassend:

    eine Vorstufenschaltung, deren Ausgangsanschluss mit dem Puffer gekoppelt ist,
    wobei die Vorstufenschaltung ein Schaltungsmodul ist, das einer Spannungsquelle (VI) mit Ausgangswiderstand äquivalent ist.

15. Integrierte Schaltung nach Anspruch 13 oder 14, wobei

    der erste Satz von Schaltern und der zweite Satz von Schaltern durch mindestens ein Signal von außerhalb der integrierten Schaltung gesteuert werden; oder
    der erste Satz von Schaltern und der zweite Satz von Schaltern durch Konfigurieren mindestens eines Registerbits innerhalb der integrierten Schaltung gesteuert werden.

## Revendications

1. Tampon comprenant :

    un amplificateur opérationnel (210), dont une borne d'entrée non inverseuse ou inverseuse est configurée pour recevoir une sortie d'un circuit de pré-étage (240) externe du tampon ;
    un réseau de réaction tension-tension (220) pour l'amplificateur opérationnel, dont une première extrémité est couplée à la borne d'entrée inverseuse de l'amplificateur opérationnel ;
    dans lequel le tampon comprend en outre :

        un résistor d'isolement (RN), dont une première extrémité est couplée à une borne de sortie (VO_BUF) du tampon ; et
        un premier groupe de commutateurs et un deuxième groupe de commutateurs (230), configurés pour fermer le premier groupe de commutateurs (SP2+SP1 ; SP3+SP4+SP5 ; SP6+SP7 ; SP3+SP4+SP5+SP8+SP9) et ouvrir le deuxième groupe de commutateurs (SN2+SN1 ; SN3+SN4+SN5 ; SN6+SN7 ; SN3+SN4+SN5+SN8+SN9) dans le cas où le tampon entraîne une première charge capacitive (CLP), et pour ouvrir le premier groupe de commutateurs et fermer le deuxième groupe de commutateurs dans le cas où le tampon entraîne une deuxième charge capacitive (CLN), de sorte que :
dans le cas où le tampon entraîne la première charge capacitive, une borne de sortie (Vo_op, Vo_op1, Vo_op2) de l'amplificateur opérationnel soit couplée à la borne de sortie du tampon par l'intermédiaire d'un premier sous-groupe de commutateurs (SP2 ; SP3+SP4 ; SP6+SP7) du premier groupe de commutateurs, et une deuxième extrémité du réseau de réaction tension-tension soit couplée à la borne de sortie du tampon par l'intermédiaire d'un deuxième sous-groupe de commutateurs (SP1 ; SP5) du premier groupe de commutateurs ou directement couplée à une deuxième extrémité du résistor d'isolement de sorte que le résistor d'isolement soit utilisé comme résistor de réaction pour l'amplificateur opérationnel, et
dans le cas où le tampon entraîne la deuxième charge capacitive, la borne de sortie de l'amplificateur opérationnel soit couplée à la deuxième extrémité du résistor d'isolement par l'intermédiaire d'un troisième sous-groupe de commutateurs (SN2 ; SN3+SN4+SN5 ; SN6+SN7) du deuxième groupe de commutateurs, et la deuxième extrémité du réseau de réaction tension-tension soit couplée à la borne de sortie de l'amplificateur opérationnel par l'intermédiaire d'un quatrième sous-groupe de commutateurs (SN1 ; SN3+SN4 ; SN6+SN7) du deuxième groupe de commutateurs,
dans lequel le premier sous-groupe, le deuxième sous-groupe, le troisième sous-groupe et le quatrième sous-groupe comprennent chacun au moins un commutateur, et le premier sous-groupe et le deuxième sous-groupe ne sont pas identiques, dans lequel le troisième sous-groupe (SN6+SN7) et le quatrième sous-groupe (SN6+SN7) sont identiques dans le cas où la deuxième extrémité du réseau de réaction tension-tension est directement couplée à la deuxième extrémité du résistor d'isolement, et le troisième sous-groupe (SN2 ; SN3+SN4+SN5) et le quatrième sous-groupe (SN1 ; SN3+SN4) ne sont pas identiques dans le cas où la deuxième extrémité du réseau de réaction tension-tension n'est pas directement couplée à la deuxième extrémité du résistor d'isolement, dans lequel la valeur de capacitance de la deuxième charge capacitive est différente de celle de la première charge capacitive.

**2.** Tampon selon la revendication 1, dans lequel la valeur de capacitance de la deuxième charge capacitive est supérieure à celle de la première charge capacitive.

**3.** Tampon selon la revendication 1 ou 2, dans lequel,

le premier groupe de commutateurs comporte un premier commutateur (SP2) et un deuxième commutateur (SP1),
le deuxième groupe de commutateurs comporte un troisième commutateur (SN2) et un quatrième commutateur (SN1),
dans lequel, le premier commutateur est couplé entre la borne de sortie de l'amplificateur opérationnel et la borne de sortie du tampon, et le deuxième commutateur est couplé entre la deuxième extrémité du réseau de réaction tension-tension et la borne de sortie du tampon, et
le troisième commutateur est couplé entre la borne de sortie de l'amplificateur opérationnel et la deuxième extrémité du résistor d'isolement, et le quatrième commutateur est couplé entre la deuxième extrémité du réseau de réaction tension-tension et la borne de sortie de l'amplificateur opérationnel,
de préférence, le premier commutateur, le deuxième commutateur, le troisième commutateur et le quatrième commutateur sont tous des grilles de transmission CMOS.

**4.** Tampon selon la revendication 1 ou 2, dans lequel,

un étage de sortie de l'amplificateur opérationnel comporte un premier transistor PMOS (MP1) et un premier transistor NMOS (MN1), dans lequel un drain du premier transistor PMOS et un drain du premier transistor NMOS sont utilisés comme bornes de sortie de l'amplificateur opérationnel ;
le premier groupe de commutateurs comporte un cinquième commutateur (SP3), un sixième commutateur (SP4), et un septième commutateur (SP5),
le deuxième groupe de commutateurs comporte un huitième commutateur (SN3), un neuvième commutateur (SN4), et un dixième commutateur (SN5),
dans lequel, le cinquième commutateur est couplé entre le drain du premier transistor PMOS et la borne de sortie du tampon, le sixième commutateur est couplé entre le drain du premier transistor NMOS et la borne de sortie du tampon, et le septième commutateur est couplé entre la deuxième extrémité du réseau de réaction tension-tension et la borne de sortie du tampon,
le huitième commutateur est couplé entre le drain du premier transistor PMOS et la deuxième extrémité du réseau de réaction tension-tension, le neuvième commutateur est couplé entre le drain du premier transistor NMOS et la deuxième extrémité du réseau de réaction tension-tension, et le dixième commutateur est couplé entre la deuxième extrémité du réseau de réaction tension-tension et la deuxième extrémité du résistor d'isolement.

**5.** Tampon selon la revendication 4, dans lequel,

le cinquième commutateur et le huitième commutateur sont tous deux des commutateurs PMOS ;
le sixième commutateur et le neuvième commutateur sont tous deux des commutateurs NMOS ;
le septième commutateur et le dixième commutateur sont tous deux des grilles de transmission CMOS.

**6.** Tampon selon la revendication 1, dans lequel,

un étage de sortie de l'amplificateur opérationnel comporte un premier transistor PMOS (MP1) et un premier transistor NMOS (MN1), dans lequel un drain du premier transistor PMOS et un drain du premier transistor NMOS sont utilisés comme bornes de sortie de l'amplificateur opérationnel ;
le premier groupe de commutateurs comporte un quinzième commutateur (SP6) et un seizième commutateur (SP7),
le deuxième groupe de commutateurs comporte un dix-septième commutateur (SN6) et un dix-huitième commutateur (SN7),
dans lequel la deuxième extrémité du réseau de réaction tension-tension est directement couplée à la deuxième extrémité du résistor d'isolement,
le quinzième commutateur est couplé entre le drain du premier transistor PMOS et la borne de sortie du tampon, et le seizième commutateur est couplé entre le drain du premier transistor NMOS et la borne de sortie du tampon,
le dix-septième commutateur est couplé entre le drain du premier transistor PMOS et la deuxième extrémité du réseau de réaction tension-tension, et le dix-huitième commutateur est couplé entre le drain du premier transistor NMOS et la deuxième extrémité du réseau de réaction tension-tension.

**7.** Tampon selon la revendication 6, dans lequel,

le quinzième commutateur et le dix-septième commutateur sont tous deux des commutateurs PMOS ;
le seizième commutateur et le dix-huitième commutateur sont tous deux des commutateurs NMOS.

8. Tampon selon l'une quelconque des revendications 4 à 7, dans lequel,

le tampon comprend en outre un premier condensateur de compensation Miller (CP1), un deuxième condensateur de compensation Miller (CP2), un troisième condensateur de compensation Miller (CN1) et un quatrième condensateur de compensation Miller (CN2) ;

le premier groupe de commutateurs comporte en outre un onzième commutateur (SP8) et un douzième commutateur (SP9) ;

le deuxième groupe de commutateurs comporte en outre un treizième commutateur (SN8) et un quatorzième commutateur (SN9) ;

dans lequel le onzième commutateur et le premier condensateur de compensation Miller sont couplés en série entre une grille du premier transistor PMOS et la borne de sortie du tampon,

le douzième commutateur et le deuxième condensateur de compensation Miller sont couplés en série entre une grille du premier transistor NMOS et la borne de sortie du tampon,

le treizième commutateur et le troisième condensateur de compensation Miller sont couplés en série entre la grille du premier transistor PMOS et la deuxième extrémité du réseau de réaction tension-tension,

le quatorzième commutateur et le quatrième condensateur de compensation Miller sont couplés en série entre la grille du premier transistor NMOS et la deuxième extrémité du réseau de réaction tension-tension.

9. Tampon selon la revendication 8, dans lequel,

le onzième commutateur et le treizième commutateur sont tous deux des commutateurs PMOS ;
le douzième commutateur et le quatorzième commutateur sont tous deux des commutateurs NMOS.

10. Tampon selon l'une quelconque des revendications 1 à 9, dans lequel,

la borne d'entrée non inverseuse de l'amplificateur opérationnel reçoit une tension fixe (VCM) ;
la borne d'entrée inverseuse de l'amplificateur opérationnel reçoit la sortie du circuit de pré-étage et est couplée à la première extrémité du réseau de réaction tension-tension ;
le réseau de réaction tension-tension comprend un premier résistor de réaction (RF1) couplé entre la première extrémité et la deuxième extrémité du réseau de réaction tension-tension,
de préférence, la résistance du premier résistor de réaction est égale à la résistance de sortie du circuit de pré-étage.

11. Tampon selon la revendication 10, dans lequel,

le circuit de pré-étage est un DAC résistif ;
la résistance du premier résistor de réaction est égale à la résistance de sortie du DAC résistif ;
la valeur de la tension fixe est égale à la moitié de la valeur maximale de tension de sortie du DAC résistif ; et
la tension de sortie du DAC résistif est une tension analogique obtenue en inversant une valeur de code numérique entrée dans le DAC résistif et en quantifiant la valeur inversée.

12. Tampon selon l'une quelconque des revendications 1 à 9, dans lequel,

la borne d'entrée non inverseuse de l'amplificateur opérationnel reçoit la sortie du circuit pré-étage ;
la borne d'entrée inverseuse de l'amplificateur opérationnel est couplée à la première extrémité du réseau de réaction tension-tension ;
le réseau de réaction tension-tension comprend un fil ou un deuxième résistor de réaction (RF2), couplé entre la première extrémité et la deuxième extrémité du réseau de réaction tension-tension,
de préférence, dans le cas où le réseau de réaction tension-tension comprend le deuxième résistor de réaction, le réseau de réaction tension-tension comprend en outre un troisième résistor de réaction (RF3) couplé entre la première extrémité du réseau de réaction tension-tension et la terre.

13. Circuit intégré comprenant :
un tampon selon l'une quelconque des revendications 1 à 12.

14. Circuit intégré selon la revendication 13, comprenant en outre :

un circuit de pré-étage, dont une borne de sortie est couplée au tampon,
dans lequel, le circuit de pré-étage est un module de circuit configuré pour être équivalent à une source de tension (VI) avec une résistance de sortie.

15. Circuit intégré selon la revendication 13 ou 14, dans lequel,

le premier groupe de commutateurs et le deuxième groupe de commutateurs sont commandés par au moins un signal externe du circuit intégré ; ou

le premier groupe de commutateurs et le deuxième groupe de commutateurs sont commandés en configurant au moins un bit de registre à l'intérieur du circuit intégré.

*FIG. 1A*

*FIG. 1B*

*FIG. 2A*

Pre-stage
circuit 240

Op-Amp
210

$R_S$

VI

Vo_op

Two sets of
switches
230

$R_N$

VO_BUF

Voltage-voltage
feedback
network 220

*FIG. 2B*

Pre-stage
circuit 240

Op-Amp
210

$R_S$

VI

Vo_op

Two sets of
switches
230

$R_N$

VO_BUF

Voltage-voltage
feedback
network 220

*FIG. 2C*

**FIG. 2D**

**FIG. 2E**

**FIG. 2F**

**FIG. 2G**

**FIG. 3A**

**FIG. 3B**

**FIG. 3C**

**FIG. 4**

**FIG. 5**

**FIG. 6**

*FIG. 7*

**FIG. 8**

**FIG. 9**

*FIG. 10*

**EP 4 645 690 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410534137
- CN 114023278 B
- KR 100427039 B1
- CN 100578596 C
- US 2009284315 A1

33